# EUROPEAN PATENT APPLICATION

(11) **EP 2 368 824 A1**
(43) Date of publication of application: **28.09.2011**
(21) Application number: 09834758.6
(22) Date of filing: 17.12.2009
(51) Int. Cl.: B65H 23/025, B65H 23/038, H01L 21/205, H01L 31/04

(54) **FLEXIBLE SUBSTRATE PROCESSING DEVICE**

(30) Priority: 24.12.2008 JP 2008327299; 13.01.2009 JP 2009004583
(71) Applicant: Fuji Electric Co., Ltd., Kawasaki shi Kanagawa (JP)
(72) Inventor: YAMADA, Takanori, Kawasaki-shi Kanagawa 210-0856 (JP); YOKOYAMA, Shoji, Kawasaki-shi Kanagawa 210-0856 (JP); FUNO, Hidekazu, Tokyo 141-0032 (JP); TSUKAHARA, Yuji, Tokyo 141-0032 (JP)
(74) Representative: Appelt, Christian W.
(86) International application number: PCT/JP2009/071018
(87) International publication number: WO 2010/073955

(57) **Abstract**

A position control device (21, 5) that controls a widthwise position of a flexible substrate 1 includes: a pair of upper nip rollers 21 (24, 25) that nip an upper edge portion of the flexible substrate, rotating shafts of the pair of upper nip rollers being inclined so that a rotation direction in a nipping portion thereof faces obliquely upward at a slight bias angle (α) with respect to a conveying direction of the flexible substrate; an upper support mechanism including a movable support member 26 and a fixed support member 27 that support the pair of upper nip rollers so that the pair of upper nip rollers can be rotated and brought close to, or withdrawn from each other; a spring 51 that biases, via the movable support member, one upper nip roller 25 of the pair of upper nip rollers in a direction of pressing against the other upper nip roller 24 of the pair of upper nip rollers; and drive means (56) for displacing the biasing member so as to adjust a nipping pressure of the pair of upper nip rollers. Occurrence of sagging and wrinkling of the flexible substrate can be inhibited, even when the strip-like flexible substrate is conveyed over a long distance, and a constant widthwise position of the flexible substrate can be maintained, thereby ensuring high-quality treatment.

## Description

### TECHNICAL FIELD

The present invention relates to a treatment apparatus in which a strip-like flexible substrate is subjected to a treatment such as film formation, while being conveyed, and more particularly to a device that controls a widthwise position of the flexible substrate.

### BACKGROUND ART

A rigid substrate is usually used as a substrate for a thin-film laminate of semiconductor films or the like. In some cases, a flexible substrate such as a plastic film is used with the object of increasing productivity and reducing cost achieved by improved convenience in handling with the substrate being reduced in weight and configured as a roll. For example, Patent Document 1 discloses an apparatus for manufacturing a thin-film laminate (thin-film photoelectric conversion element) in which a plurality of thin films of different properties are formed one on top of the other in a plurality of film forming units arranged in the conveying direction of the flexible substrate, while intermittently conveying the strip-like flexible substrate (polyimide film) supplied from an unwinding roll, and the laminate obtained is wound as a rolled product.

Patent Document 1: Japanese Patent Application Laid-open No. 2005-72408.

Such apparatuses for manufacturing a thin-film laminate can be of a type in which films are formed, while conveying the strip-like flexible substrate in a transverse posture, that is, in a state in which the widthwise direction of the substrate is a horizontal direction, and of a type in which films are formed, while conveying the strip-like flexible substrate in a vertical posture, that is, in a state in which the widthwise direction of the substrate is a vertical direction. The latter type is superior to the former type because of a smaller installation area and also because the substrate surface is more difficult to contaminate, but where the conveying span increases, a constant conveying height is difficult to maintain against the gravity, and a strong tendency is demonstrated towards wrinkling on the flexible substrate surface and sagging of the flexible substrate.

Accordingly, it has been suggested that a manufacturing apparatus in which a large number of film forming units (for example, vapor deposition units such as chemical vapor deposition units and physical vapor deposition units) are installed side by side be provided with edge position control (EPC) rollers that are in contact with the entire width of the flexible substrate between the film forming units positioned in the center of the conveying span. However, where an EPC roller formed from stainless steel or the like in order to ensure smoothness is introduced between the film forming units that are maintained at a comparatively high temperature, the flexible substrate is rapidly cooled by contact with the roller and such cooling can cause the appearance of wrinkles.

Further, the productivity can be increased and installation space can be reduced by minimizing the distance between the film forming units and reducing the margin for the flexible substrate, but if an EPC roller is installed even in one location between the film forming units, it is necessary to ensure that the spacing between all of the film forming units that are installed with the same pitch matches the EPC roller or to provide a space for the EPC roller corresponding to that of one unit, both these measures being unsuitable from the standpoint of increasing the productivity and reducing the installation space.

### DISCLOSURE OF THE INVENTION

The present invention has been created to resolve the above-described problems and it is an object thereof to provide a treatment apparatus for a flexible substrate in which the occurrence of sagging and wrinkling of the flexible substrate can be inhibited, even when the strip-like flexible substrate is conveyed over a long distance in a vertical posture, and a constant widthwise position of the flexible substrate can be maintained, thereby ensuring high-quality treatment.

(1) In order to attain the above-described object, the first basic aspect of the present invention relates to a treatment apparatus for a flexible substrate, including: conveying means (12, 14, 32, 34) for conveying a strip-like flexible substrate in a vertical posture thereof in a transverse direction, a treatment unit (20) for the flexible substrate disposed in a conveying path of the flexible substrate; and a position control device (21, 5, 5') that controls a widthwise position of the flexible substrate in the treatment unit, wherein the position control device includes a pair of upper nip rollers (24, 25) that nip an upper edge portion of the flexible substrate, rotating shafts of the pair of upper nip rollers being inclined so that a rotation direction in a nipping portion thereof faces obliquely upward at a slight bias angle with respect to a conveying direction of the flexible substrate, an upper support mechanism (26, 27) including a movable support member and a fixed support member that support the pair of upper nip rollers so that the pair of upper nip rollers can be rotated and brought close to, or withdrawn from each other, a biasing member (51, 51') that biases, via the movable support member, one of the pair of upper nip rollers in a direction of pressing against the other one of the pair of upper nip rollers, and drive means (56) for displacing the biasing member so as to adjust a nipping pressure of the pair of upper nip rollers.

In the above-described treatment apparatus, the strip-like flexible substrate is conveyed in a vertical posture by a conveying means such as feed rollers disposed upstream and downstream of the treatment unit, and the treatment such as film formation is conducted in the treatment unit. In this case, the edge portion positioned on the upper side of the flexible substrate is nipped by the nip roller pair constituting the position control device, and the rotation direction in the nipping portion of the nip roller pair faces obliquely upward at a slight bias angle with respect to the conveying direction of the flexible substrate. As a result, it is possible to generate a force that will lift the flexible substrate upward against sagging caused by the gravity. This lifting force depends on the nipping pressure of the nip roller pair, that is, on the biasing force of the biasing member. Therefore, by displacing the biasing member with the drive means and adjusting the biasing force of the biasing member, it is possible to control the position of the strip-like flexible substrate in the vertical width direction and maintain this position at a constant level or within a predetermined tolerance range.

Since a constant position of the flexible substrate in the vertical width direction can thus be maintained and sagging can be inhibited, even when the strip-like flexible substrate is conveyed over a long distance in a vertical posture, the flexible substrate can be uniformly tensioned in the conveying span and the occurrence of wrinkles or strains can be prevented. Therefore, high quality treatment of the flexible substrate can be performed. Furthermore, since the nip roller pair only nips the edge portion positioned on the upper side of the strip-like flexible substrate, no adverse effect is produced on portions of the product. In addition, since small-diameter and small-width rollers can be used, the rollers can be disposed in a very small space between the treatment units, spacing of the treatment units and margin for the flexible substrate can be minimized, productivity can be increased and the installation space can be reduced.

(2) In order to attain the above-described object, the second basic aspect of the present invention relates to a treatment apparatus for a flexible substrate, including: conveying means (12, 14, 32, 34) for conveying a strip-like flexible substrate in a vertical posture thereof in a transverse direction; a treatment unit (20) for the flexible substrate disposed in a conveying path of the flexible substrate; and a position control device (21, 8, 8', 8") that controls a widthwise position of the flexible substrate in the treatment unit, wherein the position control device includes a pair of upper nip rollers (24, 25) that nip an upper edge portion of the flexible substrate, rotating shafts of the pair of upper nip rollers being inclined so that a rotation direction in a nipping portion thereof faces obliquely upward at a slight bias angle with respect to a conveying direction of the flexible substrate, an upper support mechanism (28, 29) including a movable support member and a fixed support member that support the pair of upper nip rollers so that the pair of upper nip rollers can be rotated and brought close to, or withdrawn from each other, a biasing member (81, 81') that biases, via the movable support member, one of the pair of upper nip rollers in a direction of pressing against the other one of the pair of upper nip rollers, a second biasing member (82, 82') that applies to the movable support member an adjusting force in a direction opposite to a biasing direction of the biasing member, and drive means (86) for displacing the second biasing member so as to adjust a nipping pressure of the pair of upper nip rollers.

In the apparatus according to the first basic aspect, the position control unit has a configuration in which the nipping pressure is adjusted by directly displacing the biasing member with the drive means, whereas in the apparatus according to the second basic aspect, the second biasing member is provided that applies to the movable support member an adjusting force in the direction opposite to the biasing direction of the biasing member (first biasing member), the biasing force (adjusting force) of the second biasing member is adjusted by displacing the second biasing member with the drive means, the biasing force of the first biasing member is canceled by the changed adjusting force, and the nipping pressure of the nip roller pair is adjusted.

Therefore, in the apparatus according to the second basic aspect, the biasing force of the first biasing member acts at all times via the movable support member upon the nip roller pair. Furthermore, the biasing force of the first biasing member and the biasing force (adjusting force) of the second biasing member increase in a region with a low nipping pressure of the nip roller pair, that is, in a region in which the shift of position in the vertical width direction is small and the position control converges. As a result, control accuracy and stability can be improved. Other operation effects are similar to those of the first basic aspect.

In an apparatus for manufacturing a thin-film laminate for which the treatment apparatus for a flexible substrate in accordance with the present invention is mainly intended, the principal components of the manufacturing apparatus including the film forming units are provided inside a common vacuum chamber, but it is difficult to dispose a drive means including an actuator such as a motor or a hydraulic cylinder inside the vacuum chamber that is evacuated to a predetermined vacuum level and maintained at a comparatively high temperature. Accordingly, the present invention includes the below-described secondary aspects that relate to the arrangement of the above-described biasing means when providing a configuration in which the nipping pressure of the nip roller pair is remotely operated by an actuator disposed outside the vacuum chamber.

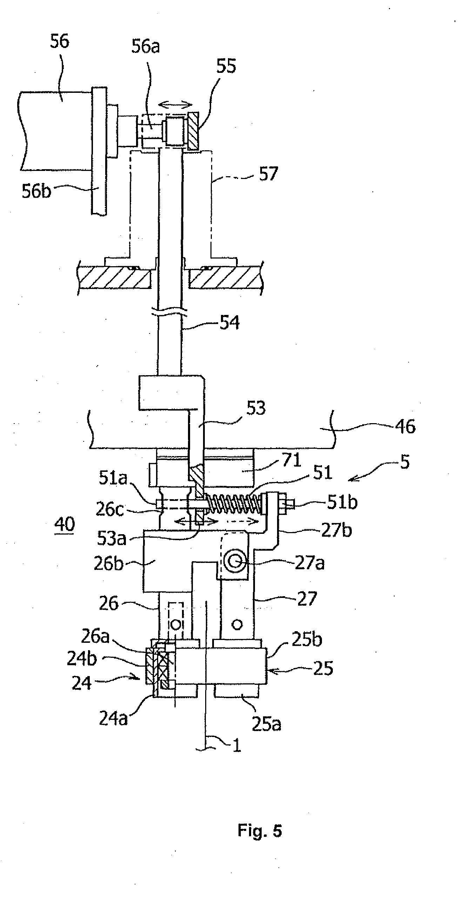

(1.1) According to the first secondary aspect based on the above-described first basic aspect, the treatment unit includes at least one film forming unit (41) provided inside a vacuum chamber, the pair of upper nip rollers (24, 25), the upper support mechanism (26, 27), and the biasing member (51) are provided inside the vacuum chamber, and the drive means includes an actuator (56) provided outside the vacuum chamber and a drive transmission mechanism (55, 54, 53) that transmits drive of the actuator via sealing means (57) to the biasing member (51) inside the vacuum chamber (FIG. 5).

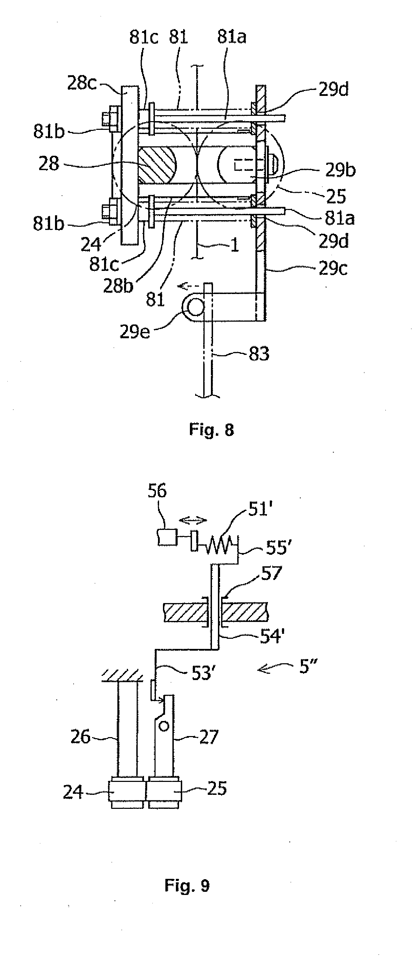

(1.2) According to the second secondary aspect based on the above-described first basic aspect, the treatment unit includes at least one film forming unit (41) provided inside a vacuum chamber, the pair of upper nip rollers (24, 25) and the upper support mechanism (26, 27) are provided inside the vacuum chamber, and the biasing member (51') is provided outside the vacuum chamber, and the drive means includes an actuator (56) provided outside the vacuum chamber and further includes a biasing force transmission mechanism (55', 54', 53') that transmits a biasing force of the biasing member via sealing means (57) to the movable support member inside the vacuum chamber (FIG. 9).

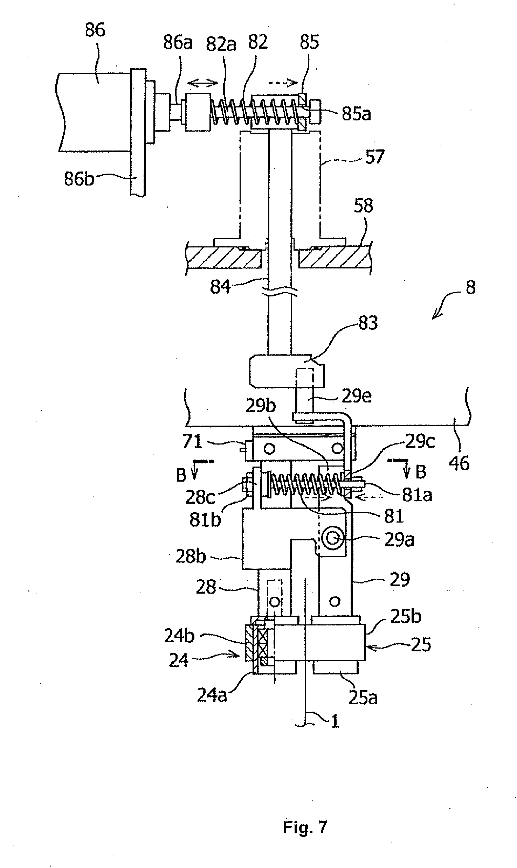

(2.1) According to the first secondary aspect based on the above-described second basic aspect, the treatment unit includes at least one film forming unit (41) provided inside a vacuum chamber, the pair of upper nip rollers (24, 25), the upper support mechanism (28, 29), and the biasing member (81) are provided inside the vacuum chamber, and the second biasing member (82) is provided outside the vacuum chamber, and the drive means includes an actuator (86) provided outside the vacuum chamber and further includes an adjusting force transmission mechanism (85, 84, 83) that transmits an adjusting force of the second biasing member via sealing means (57) to the movable support member inside the vacuum chamber (FIG. 7).

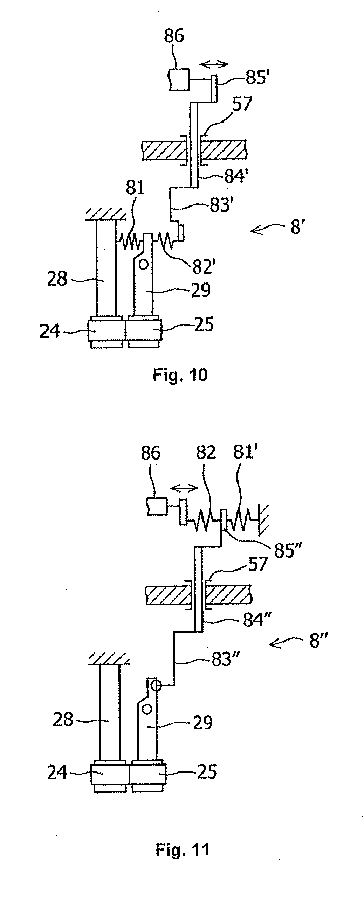

(2.2) According to the second secondary aspect based on the above-described second basic aspect, the treatment unit includes at least one film forming unit (41) provided inside a vacuum chamber, the pair of upper nip rollers (24, 25), the upper support mechanism (28, 29), the biasing member (81), and the second biasing member (82') are provided inside the vacuum chamber, and the drive means includes an actuator (86) provided outside the vacuum chamber and a drive transmission mechanism (85', 84', 83') that transmits drive of the actuator via sealing means (57) to the second biasing member inside the vacuum chamber (FIG. 10).

(2.3) According to the third secondary aspect based on the above-described second basic aspect, the treatment unit includes at least one film forming unit (41) provided inside a vacuum chamber, the pair of upper nip rollers (24, 25) and the upper support mechanism (28, 29) are provided inside the vacuum chamber, and the biasing member (81') and the second biasing member (82) are provided outside the vacuum chamber, and the drive means includes an actuator (86) provided outside the vacuum chamber and a biasing force transmission mechanism (85", 84", 83") that transmits a biasing force of the biasing member via sealing means (57) to the movable member inside the vacuum chamber (FIG. 11).

In the above-described secondary aspects of the present invention, it is preferred that the sealing means (57) be a seal bearing, the drive transmission mechanism, the biasing force transmission mechanism, or the adjusting force transmission mechanism include a shaft (54, 54', 84, 84', 84") that is air-tightly and rotatably supported by the seal bearing, and a rotational force be transmitted from outside to inside of the vacuum chamber via the shaft.

In the configuration, in which the nipping pressure of the nip roller pair is remotely operated from the outside of the vacuum chamber, transmitting a rotation force via the shaft that is air-tightly and rotatably supported by the seal bearing provided in the partition wall of the vacuum chamber is useful because a load on the seal structure is small, the drive force, biasing force, or adjusting force can be transmitted into the vacuum chamber with good efficiency, and the accuracy of substrate position control is ensured.

In accordance with the present invention, it is preferred that the position control device further include a pair of lower nip rollers (23) that nip a lower edge portion of the flexible substrate, rotating shafts of the pair of lower nip rollers being inclined so that a rotation direction in a nipping portion thereof faces obliquely downward at a slight bias angle with respect to a conveying direction of the flexible substrate, a lower support mechanism including a movable support member and a fixed support member that support the pair of lower nip rollers so that the pair of lower nip rollers can be rotated and brought close to, or withdrawn from each other, and a lower biasing member that biases, via the movable support member, one of the pair of lower nip rollers in a direction of pressing against the other one of the pair of lower nip rollers.

With such a configuration, the strip-like flexible structure is stretched in the vertical direction, that is, widthwise direction by a controllable lifting force created by the upper nip roller pair and a pull-down force created by the lower nip roller pair and the control of position in the vertical width direction is performed in a stretched state. As a result, the position control is performed with higher accuracy.

In the above-described configuration the lower drive means that displaces the lower biasing means in order to adjust the nipping pressure of the pair of lower nip rollers is further provided, or the lower second biasing member that applies an adjusting force to the movable support member in the direction opposite that of the biasing force of the lower biasing member and the lower drive means that displaces the lower second biasing means in order to adjust the nipping pressure of the pair of lower nip rollers are further provided.

(3) In order to attain the above-described object, the third basic aspect of the present invention relates to a treatment apparatus for a flexible substrate, including: conveying means (12, 14, 32, 34) for conveying a strip-like flexible substrate in a vertical posture thereof in a transverse direction; a treatment unit (20) for the flexible substrate disposed in a conveying path of the flexible substrate; and a position control device (121, 105) that controls a widthwise position of the flexible substrate in the treatment unit, wherein the position control device includes a pair of upper nip rollers (124, 125) that nip an upper edge portion of the flexible substrate, rotating shafts of the pair of upper nip rollers being inclined so that a rotation direction in a nipping portion thereof faces obliquely upward at a slight bias angle with respect to a conveying direction of the flexible substrate, a support mechanism (128, 129) including a movable support member and a fixed support member that support the pair of upper nip rollers so that the pair of upper nip rollers can be rotated and brought close to, or withdrawn from each other, a spring (160) that generates a biasing force that presses, via the movable support member, one of the pair of upper nip rollers against the other one of the pair of upper nip roller, a transmission mechanism (151, 153, 154) that transmits the biasing force of the spring as a torque to the movable support member, and drive means (156) for angularly displacing a support point of the spring about a point of connection to the transmission mechanism so as to adjust a nipping pressure of the pair of upper nip rollers.

In the third basic aspect, a configuration is used in which a support point of the spring is angularly displaced about a point of connection to the transmission mechanism in order to adjust the nipping pressure of the nip roller pair, thereby making it possible to increase or decrease gradually the angular component of the biasing force contributing to the nipping pressure of the nip roller pair, that is, a component perpendicular to the rotation radial direction of the spring support point, in response to the angular displacement of the spring support point even in a state in which a constant elastic displacement of the spring is maintained. The advantage of such a configuration over that in which the spring support point is displaced back and forth in the action direction of the biasing force is that the drive force required to perform the control is reduced, the structure is simplified, and high-accuracy control is performed.

In particular, the biasing force of the spring acts upon the transmission mechanism at all times in the entire region of angular displacement including a region in which the nipping pressure of the nip roller pair is small. Furthermore, the component in the rotation radial direction of the spring support point increases with the decrease in the angular component of the biasing force contributing to the nipping pressure of the hip roll pair, and this radial component contributes to stabilization of angular position of the transmission mechanism and the nipping pressure of the hip roll pair corresponding thereto. Therefore, the above-described configuration is useful in terms of increasing the accuracy and stability of control in a region in which the nipping pressure of the hip roll pair is small, that is, a region in which the displacement of the flexible substrate position in the vertical width direction is small and the position control converges.

In the third basic aspect, it is preferred that the drive means include a drive member (161) that angularly displaces the support point of the spring about an axis passing through the point of connection to the transmission mechanism and parallel to a rotating shaft of the transmission mechanism, while maintaining a constant elastic displacement of the spring. The merit of this aspect is that it is possible to create easily a system in which the effect of friction accompanying elastic deformation of the spring is eliminated and high-quality control is performed and, in addition, the release position of the nip roller using a toggle mechanism, such as described hereinbelow, can be set by the drive means.

Thus, in another preferred embodiment of the present invention, the angular displacement of the support point induced by the drive means is a toggle angular position and includes a toggle angular position (161') such that the transmission mechanism can be held by the biasing force of the spring supported in the toggle angular position in two positions: a position in which the one of the pair of nip rollers is pressed against the other one of the pair of nip rollers; and a position in which the one of the pair of nip rollers is withdrawn from the other one of the pair of nip rollers.

With such a configuration, a standby state in which one of the pair of nip rollers can be withdrawn from the other one of the pair of nip rollers can be attained by displacing the spring support point to the toggle angle position with the drive means, while maintaining the connection relationship of the movable support member, transmission mechanism, spring, and drive means. Furthermore, where one of the pair of nip rollers is manually withdrawn from the other one of the pair of nip rollers, the withdrawn nip roller is held in the withdrawn state by the biasing force of the spring and the flexible substrate can be easily introduced in the manufacturing apparatus. Further, where the withdrawn nip roller is returned to the original position after the flexible substrate has been passed into the film forming unit, the nip roller is immediately pressed against the other one of the pair of nip rollers by the biasing force of the spring and the flexible substrate is nipped. The operation of introducing the flexible substrate can thus be facilitated.

In another preferred embodiment of the present invention, the position control device further includes a pair of lower nip rollers (123) that nip a lower edge portion of the flexible substrate, rotating shafts of the pair of lower nip rollers being inclined so that a rotation direction in a nipping portion thereof faces obliquely downward at a slight bias angle with respect to a conveying direction of the flexible substrate, a lower support mechanism including a movable support member and a fixed support member that support the pair of lower nip rollers so that the pair of lower nip rollers can be rotated and brought close to, or withdrawn from each other, and a lower spring that generates a biasing force that presses, via the movable support member, one of the pair of lower nip rollers against the other one of the pair of lower nip rollers.

With the configuration in which a pair of lower nip rollers that nip the lower edge of a strip-like flexible substrate is added to the above-described pair of upper nip rollers that nip the upper edge of the flexible substrate, the upper nip roller pair has a slight bias angle such that the rotation direction thereof faces obliquely upward, and the lower nip roller pair has a slight bias angle such that the rotation direction thereof faces obliquely downward, the strip-like flexible structure is stretched in the vertical direction, that is, widthwise direction by a controllable lifting force created by the upper nip roller pair and a pull-down force created by the lower nip roller pair and the control of position in the vertical width direction is performed in a stretched state. As a result, the position control is performed with higher accuracy.

In accordance with the present invention, it is preferred that the treatment apparatus for a flexible substrate further include detection means (49) for detecting a position of the flexible substrate in a vertical width direction and the position control device further include a control unit (50, 150) for controlling the drive means on a basis of a detection value of the detection means. With such a configuration, automatic control such as based on feedback control can be performed by implementing in advance the calibration of nipping pressure and control amount (angular displacement).

For example, when films are formed, while intermittently conveying the strip-like substrate with a predetermined pitch, the detection of position in the vertical width direction and, if necessary, the adjustment of nipping pressure are implemented in parallel with the film formation process in the stop periods, the substrate position can be corrected by a conveying force of the conveying means within the next conveying period, and the position in the vertical width direction can be monitored and the nip pressure can be corrected in the conveying period. Further, when films are formed, while conveying the strip-like substrate continuously, the nipping pressure can be corrected as necessary, while monitoring the position in the vertical width direction at all times.

(4) In the following embodiments of the above-described first to third basic aspects of the present invention, where pairs of nip rollers are provided at each side edge of the flexible substrate, not only the vertical posture, but also the transverse posture can be controlled.

(4.1) Thus, the above-described first basic aspect can be implemented as a treatment apparatus for a flexible substrate, including: conveying means for conveying a strip-like flexible substrate; a treatment unit for the flexible substrate disposed in a conveying path of the flexible substrate; and a position control device that controls a widthwise position of the flexible substrate in the treatment unit, wherein the position control device includes pairs of nip rollers that nip side edge portions of the flexible substrate, rotating shafts of the pairs of nip rollers being inclined so that rotation directions in nipping portions thereof face widthwise edges at a slight bias angle with respect to a conveying direction of the flexible substrate, support mechanisms on each side including movable support members and fixed support members that support the pairs of nip rollers so that the pairs of nip rollers can be rotated and brought close to, or withdrawn from each other, biasing members on each side that bias, via the movable support members, one of the nip roller in each pair in a direction of pressing against the other one of the nip rollers, and drive means for displacing at least one of the biasing members so as to adjust a nipping pressure of at least one of the pairs of nip rollers.

(4.2) Thus, the above-described second basic aspect can be implemented as a treatment apparatus for a flexible substrate, including: conveying means for conveying a strip-like flexible substrate; a treatment unit for the flexible substrate disposed in a conveying path of the flexible substrate; and a position control device that controls a widthwise position of the flexible substrate in the treatment unit, wherein the position control device includes pairs of nip rollers that nip side edge portions of the flexible substrate, rotating shafts of the pairs of nip rollers being inclined so that rotation directions in nipping portions thereof face widthwise edges at a slight bias angle with respect to a conveying direction of the flexible substrate, support mechanisms on each side including movable support members and fixed support members that support the pairs of nip rollers so that the pairs of nip rollers can be rotated and brought close to, or withdrawn from each other in each pair, biasing members on each side that bias, via the movable support members, one of the nip rollers in each pair in a direction of pressing against the other one of the nip rollers, second biasing members on each side that apply to the movable support members an adjusting force in a direction opposite to a biasing direction of the biasing members, and drive means for displacing at least one of the second biasing members so as to adjust a nipping pressure of at least one of the pairs of nip rollers.

(4.3) Thus, the above-described third basic aspect can be implemented as a treatment apparatus for a flexible substrate, including: conveying means for conveying a strip-like flexible substrate; a treatment unit for the flexible substrate disposed in a conveying path of the flexible substrate; and a position control device that controls a widthwise position of the flexible substrate in the treatment unit, wherein the position control device includes pairs of nip rollers that nip side edge portions of the flexible substrate, rotating shafts of the pairs of nip rollers being inclined so that rotation directions in nipping portions thereof face widthwise edges at a slight bias angle with respect to a conveying direction of the flexible substrate, support mechanisms on each side including movable support members and fixed support members that support the pairs of nip rollers so that the pairs of nip rollers can be rotated and brought close to, or withdrawn from each other in each pair, springs on each side that generate biasing forces that press, via the movable support members, one of the nip rollers in each pair against the other one of the nip rollers, transmission mechanisms on each side that transmit the biasing forces of the springs as respective torques to the movable support members, and drive means for angularly displacing a support point of at least one of the springs about a point of connection to the transmission mechanism so as to adjust a nipping pressure of at least one of the pairs of nip rollers.

As describes hereinabove, with the treatment apparatus for a flexible substrate in accordance with the present invention, the occurrence of sagging and wrinkling of the flexible substrate can be inhibited, and a constant widthwise position of the flexible substrate can be maintained, thereby ensuring high-quality treatment when the treatment such as film formation is conducted while conveying the strip-like flexible substrate. In addition, according to the above-described third basic aspect, high-accuracy control can be performed with a small drive force, and a release mechanism for a nip roll pair that facilitates the introduction of the flexible substrate can be mounted at a low cost.

### BRIEF DESCRIPTION OF THE DRAWINGS

FIG. 1 is a schematic plan view illustrating the entire configuration of the manufacturing apparatus according to an embodiment of the present invention.
FIG. 2 is a schematic plan view illustrating one film forming unit of the manufacturing apparatus according to an embodiment of the present invention.
FIG. 3 is a sectional view taken along A-A in FIG. 2.
FIG. 4 is a principal enlarged cross-sectional view of the configuration shown in FIG. 3 that illustrates an upper nip roller pair and a control mechanism thereof according to the first embodiment of the present invention.
FIG. 5 is a principal enlarged cross-sectional view in which the upper nip roller pair and the control mechanism thereof according to the first embodiment of the present invention are viewed from the upstream side in the conveying direction.
FIG. 6 is a principal enlarged cross-sectional view corresponding to FIG. 4 that illustrates an upper nip roller pair and a control mechanism thereof according to the second embodiment of the present invention.
FIG. 7 is a principal enlarged cross-sectional view in which the upper nip roller pair and the control mechanism thereof according to the second embodiment of the present invention are viewed from the upstream side in the conveying direction.
FIG. 8 is a sectional view taken along B-B in FIG. 7.
FIG. 9 is a schematic drawing illustrating a modification example relating to the first embodiment of the present invention.
FIG. 10 is a schematic drawing illustrating a modification example relating to the second embodiment of the present invention.
FIG. 11 is a schematic drawing illustrating another modification example relating to the second embodiment of the present invention.
FIG. 12 is a schematic cross-sectional view taken along A-A in FIG. 2, the drawing illustrating another modification example relating to the first embodiment of the present invention.
FIG. 13 is a cross-sectional view taken along A-A in FIG. 2 illustrating one film forming unit of the manufacturing apparatus according to the third embodiment of the present invention.
FIG. 14 is a principal enlarged cross-sectional view corresponding to FIG. 3 that illustrates an upper nip roller pair and a control mechanism thereof according to the third embodiment of the present invention.
FIG. 15 is a principal enlarged cross-sectional view in which the upper nip roller pair and the control mechanism thereof according to the third embodiment of the present invention are viewed from the upstream side in the conveying direction.
FIG. 16 is a principal enlarged plan sectional view illustrating the upper nip roller pair and the control mechanism thereof according to the third embodiment of the present invention.
FIG. 17 is a graph illustrating the relationship between a rotation angle of a drive arm, a tension F of a spring, a biasing direction component Fy, and a component Fx perpendicular to the biasing direction.
FIG. 18 is a principal enlarged cross-sectional view in which the upper nip roller pair of a constant contact pressure type is viewed from the upstream side in the conveying direction.
FIG. 19 is a schematic cross-sectional view taken along A-A in FIG. 2 that illustrates a modification example according to the third embodiment of the present invention.
FIG. 20 is a schematic cross-sectional view in which an upper nip roller pair and a control mechanism thereof according to the fourth embodiment of the present invention are viewed from the upstream side in the conveying direction.

### EXPLANATION OF REFERENCE NUMERALS

1 flexible substrate
5, 5', 8, 8', 8" control mechanisms (contact pressure adjusting units)
7 angle adjusting means
10 unwinding unit
11 unwinding roll
12 unwinding feed roller
13a, 13b tension detection rollers
14 guider roller
20 film forming unit
21, 22 upper nip roller pairs
23, 23' lower nip roller pairs
24 fixed roller
25 movable roller
26, 28 fixed support members
27, 29 movable support members
128 extension arm
129 bracket
30 winding unit
31 winding roll
32 winding feed roller
33a, 33b tension detection rollers
34 guider roller
35 side end position control roller
40 chamber structure unit (vacuum chamber)
41 film forming unit
42 fixed chamber
43 movable chamber
46 main structural member
48 top panel
49, 49' sensors
50 control unit
51, 51' springs (biasing members)
53, 53' operation arms
54, 54' rotating shafts
55, 55' levers
56, 56' actuators
57, 57' seal bearings
81, 81', 81" springs (first biasing members)
82, 82', 82" springs (second biasing members)
83, 83', 83" operation arms
84, 84', 84" rotating shafts
85, 85', 85" levers
86 actuator
100 manufacturing apparatus
105, 105' control mechanisms (contact pressure adjusting units)
121, 122 upper nip roller pairs
123, 123' lower nip roller pairs
124 fixed roller
125 movable roller
126 fixed support member
127 movable support member
150 control unit
151 second arm
154 rotating shaft
153 first arm
153a connecting pin (connection point)
156, 156' actuators (drive means)
157 seal bearing
160 spring
160a adjusting screw
161 drive arm
161a support pin (support point)
300 manufacturing apparatus
305 control mechanism (contact pressure adjusting unit)
307 angle adjusting means
321 nip roller pair
324 fixed roller
325 movable roller
326 fixed support member
327 movable support member
340 chamber structure unit (vacuum chamber)
341 film forming unit
342 fixed chamber
343 movable chamber
346 main structural member
348 top panel
349 sensor
350 control unit
351 spring (biasing means)
354 rotating shaft
356 actuator
357 seal bearing
α, β slight bias angles

### BEST MODE FOR CARRYING OUT THE INVENTION

A case in which the present invention is implemented in the manufacturing apparatus 100 for a thin-film laminate constituting a thin-film photoelectric conversion element for a solar cell will be explained below in greater detail with reference to the appended drawings as an embodiment of the present invention. In the description below, common or corresponding components in the embodiments will be assigned with common or corresponding reference numerals and the explanation thereof will be herein omitted.

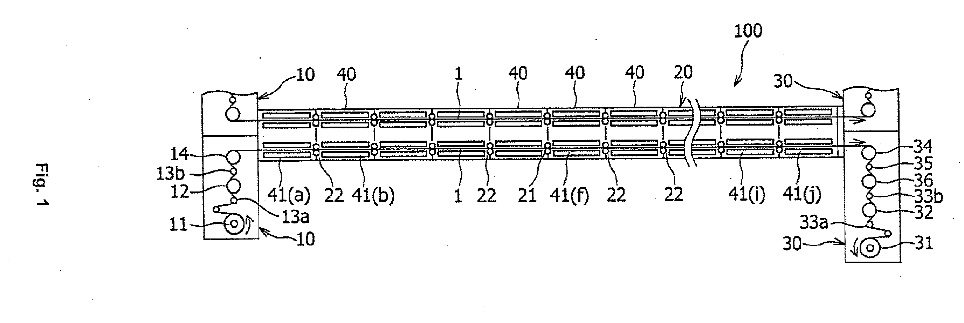

In FIG. 1, the manufacturing apparatus 100 includes an unwinding unit 10 and a winding unit 30 constituting a conveying system for a strip-like flexible substrate 1 (flexible film) and is configured so that a plurality of thin films are successively laminated and formed on the flexible substrate 1 in a film forming section 20 provided along the conveying path between the unwinding unit and winding unit, while the flexible substrate 1 is intermittently conveyed with a predetermined pitch from the unwinding unit 10 to the winding unit 30, so that the transverse direction of the flexible substrate coincides with the vertical direction.

Chamber structures covering the unwinding unit 10, the film forming units 20, and the winding unit 30 are air-tightly joined to each other, and the entire apparatus is accommodated in a common vacuum chamber maintained under a predetermined degree of vacuum. In the manufacturing apparatus 100 shown by way of example in the figure, production lines of two systems for thin-film laminates are laid out in parallel and the unwinding device 10 and the winding device 30 are provided for each system, but the film forming section 20 is accommodated inside the chamber structures (40, 40...) common to the two systems.

The unwinding unit 10 is mainly constituted by an unwinding device (11) that unwinds and supplies the flexible substrate 1 from an unwinding roll 11, an unwinding feed roller 12 that feeds the unwound flexible substrate 1 to the film forming section 20, tension detection rollers 13a and 13b that detect the film tension on the unwinding side, and a guide roller 14 that guides the flexible substrate 1 to the film forming section 20 upstream of the film forming section 20.

The winding unit 30 provided downstream of the film forming section 20 is mainly constituted by a guide roller 34 that guides the flexible substrate 1 downstream of the film forming section 20, an edge position control (EPC) roller 35 that controls position of the flexible substrate 1 in the guider roller 34 in the vertical width direction (conveying height), an idle roller 36, tension detection rollers 33a, 33b that detect the film tension on the winding side, a winding feed roller 32, and a winding device (31) that winds up the flexible substrate 1 on the circumference of a core as a winding roll 31. The tension detection roller 33b also has a function of actively controlling the film tension.

The rollers constituting the unwinding unit 10 and the winding unit 30 are oriented so that the axial direction thereof coincides with the vertical direction in order to convey the flexible substrate 1 so that the transverse direction thereof coincides with the vertical direction. The edge position control roller 35 is configured such that the axial direction thereof can be inclined with respect to the vertical direction, the rotation axis of the edge position control roller is inclined on the basis of the detection value of the position of the flexible substrate 1 in the vertical width direction in the guide roller 34, and the feed-out direction of the flexible substrate 1 is finely adjusted up or down, thereby making it possible to correct and maintain a constant position of the flexible substrate 1 in the vertical width direction in the guider roller 34.

The film forming section 20 is constituted by a plurality of film forming units 41 arranged with a predetermined pitch along the linear conveying path of the flexible substrate 1 between the unwinding unit 10 and the winding unit 30. A chamber structure of the film forming section 20 is composed of a plurality of chamber structure units 40 compartmentalized for each film forming unit 41. The chamber structure units 40 are air-tightly joined to each other and constitute part of the aforementioned common vacuum chamber. Each film forming unit 41 is constituted by a vacuum vapor deposition unit for performing chemical vapor deposition (CVD) such as plasma CVD or physical vapor deposition (PVD) such as sputtering.

For example, the manufacturing apparatus (100) for a thin-film solar cell in which photoelectric conversion elements are laminated and formed on the flexible substrate 1 includes a plurality of film forming units 41 (a, b...) in which photoelectric conversion layers of a pin structure are laminated and formed by plasma CVD and a plurality of film forming units 41 (i, j) in which the respective electrode layers are laminated and formed by sputtering on the front surface of the photoelectric conversion layer and the rear surface of the flexible substrate 1.

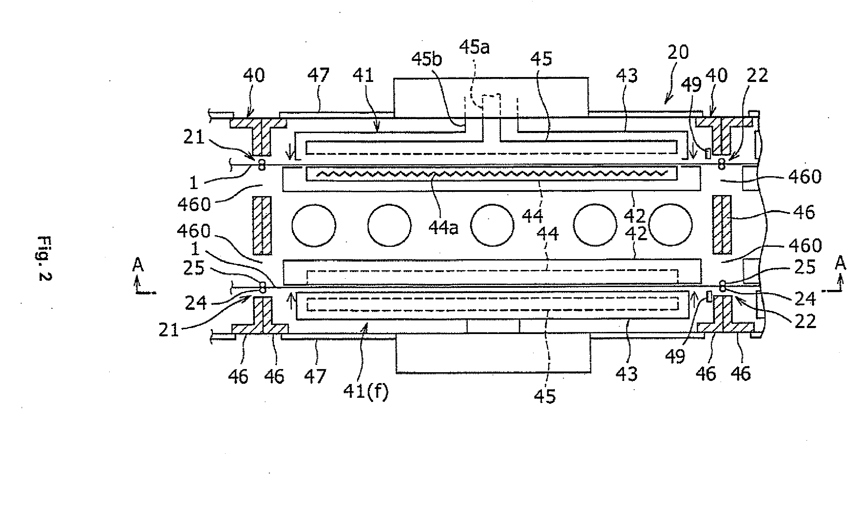

FIG. 2 shows schematically one film forming unit 41 for plasma CVD. As shown in the figure, the film forming unit 41 includes a fixed chamber 42 in which the mutually opposing faces are open and a movable chamber 43 that can be brought into contact with and separated from the fixed chamber 42 by a reciprocating drive means such as a hydraulic cylinder (not shown in the figure), and a ground electrode 44 incorporating a heater 44a is provided inside the fixed chamber 42. Further, a high-frequency electrode 45 having a large number of gas ejection holes in the surface is provided inside the movable chamber 43, and the high-frequency electrode 45 is connected to a high-frequency power source (not shown in the figure) located outside the vacuum chamber.

In the film forming unit 41, the movable chamber 43 is pressed against the fixed chamber 42 and the flexible substrate 1 is nipped therebetween in a stop period of an intermittent conveying cycle of the flexible substrate 1, the film forming chambers (42, 43) are closed in this state, a starting material gas including film forming components is then introduced into the film forming chambers (42, 43) through a gas introducing tube 45a, while the inside of the film forming chambers (42, 43) is being further evacuated via an evacuation tube 45b, plasma is generated by applying a high-frequency high voltage to the high-frequency electrode 45, and a film can be formed by a chemical reaction of the starting material gas on the surface of the heated flexible substrate 1.

When a plurality of photoelectric conversion layers are provided with the object of increasing power generation efficiency of a thin-film solar cell, the total number of film forming units 41 is equal to or greater than ten, and with a large flexible substrate 1 having a width equal to or greater than 1 m, a conveying span from the unwinding guide roller 14 to the winding guide roller 34 can be equal to or greater than 10 m. Accordingly, the manufacturing apparatus 100 is provided with a substrate position control device that maintains a constant position of the flexible substrate 1 in the vertical width direction (conveying height) in the film forming section 20.

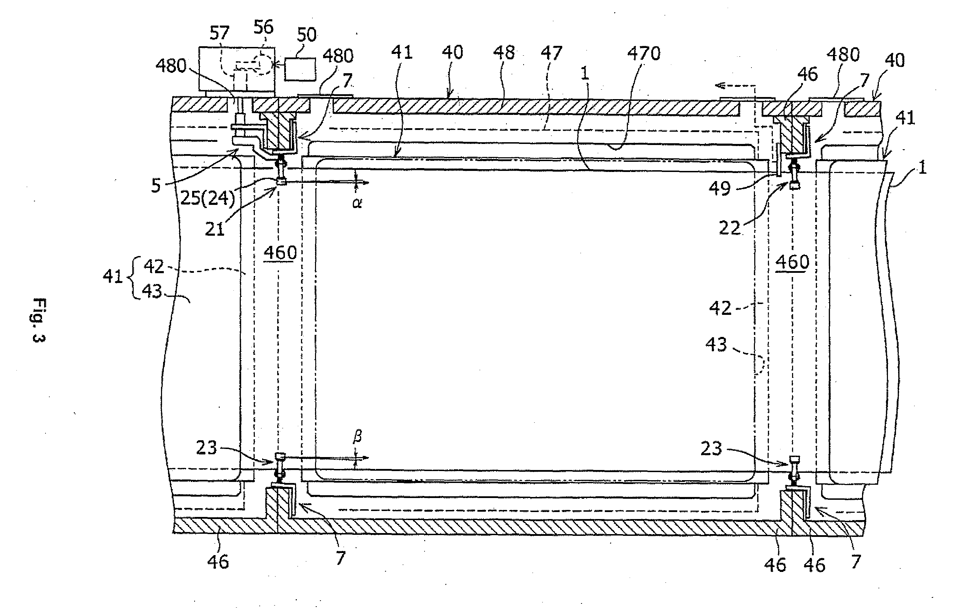

As shown in FIG. 2 and FIG. 3, the substrate position control device is provided between the film forming units 41, 41... in the film forming section 20 with upper nip roller pairs 21, 22... nipping the upper edge of the flexible substrate 1 and lower nip roller pairs 23, 23... nipping the lower edge of the flexible substrate 1, wherein at least one upper nip roller pair 21 is configured to be capable of controlling the nipping pressure. The substrate position control device also includes a sensor 49 detecting the position of the flexible substrate 1 in the vertical width direction, a control unit 50 that controls the nipping pressure of at least one upper nip roller pair 21 on the basis of the detection value of the sensor 49, and an actuator 56 serving as a drive means.

As mentioned hereinabove, the film forming section 20 is composed of a plurality of chamber structure units 40 compartmentalized for each film forming unit 41, and each chamber structural unit 40 is constituted by main structural members 46 provided on the circumference thereof, side walls 47 that can be opened and closed with respect to the main structural members 46, and a top panel 48 fixed to the upper portion of the main structural members 46. The movable chamber 43 including the high-frequency electrode 45 and a reciprocating driving means (not shown in the figure) therefor are mounted on side walls 47. In the joint portion of chamber structure units 40, an opening 460 for passing the flexible substrate 1 is provided through each main structural member 46, and the upper nip roller pairs 21, 22... and the lower nip roller pairs 23, 23... are attached to the main structural members 46 at the below-described slight bias angles α, β, with the below-described angle adjusting means 7 being interposed therebetween, above and below the opening 460.

Thus, the upper nip roller pairs 21, 22... are attached so that the rotation directions thereof in the nipping portion face obliquely upward at a slight bias angle α with respect to the conveying direction of the flexible substrate 1, and the lower nip roller pairs 23, 23... are attached so that the rotation directions thereof in the nipping portion face obliquely downward at a slight bias angle β with respect to the conveying direction of the flexible substrate 1.

Where the upper nip roller pairs 21, 22 and the lower nip roller pairs 23 are so provided with slight bias angles α, β such that the roller pairs mutually expand with respect to the conveying direction, not only the flexible substrate 1 is supported within the conveying span, but also a lifting force is generated at the upper edge of the flexible substrate 1 and a pull-down force is generated at the lower edge in the process of conveying along the film forming units 41. As a result, the flexible substrate 1 is spread in the transverse direction, the lifting force of the upper nip roller pairs 21, 22 is in the equilibrium with a force obtained by adding the pull-down force of the lower nip roller pairs 23 to the force of gravity of the flexible substrate 1, the position of the flexible substrate 1 in the vertical width direction is fixed, and a pass line becomes horizontal. However, film forming processes are successively performed on the flexible substrate 1 in the film forming units 41, physical properties such as surface density and elastic modulus of the flexible substrate 1 are not always uniform in the conveying direction, and the equilibrium state cannot be easily obtained.

The lifting force of the upper nip roller pairs 21, 22 and the pull-down force of the lower nip roller pairs 23 depend on the slight bias angles α, β and a contact pressure of the nip roller pairs. The slight bias angles α, β can be set within a range of 0.1° to 6° and also depend on surface state and contact pressure of the flexible substrate 1 and nip roller pairs, but where the slight bias angles α, β are greater than about 6°, dynamic friction becomes predominant and the lifting force or pull-down force does not increase. To ensure effective functioning of substrate position control, it is preferred that the slight bias angles α, β be 0.5° to 2°. Where the upper and lower slight bias angles α, β are constant, the lifting force and pull-down force of roller pairs are determined by contact pressure. However, it is unrealistic to control the contact pressure of all of the upper nip roller pairs 21, 22 and the lower nip roller pairs 23 provided along the conveying direction between the film forming units 41.

Accordingly, a configuration is used in which a contact pressure of some of the upper nip roller pairs 21 from among the upper nip roller pairs 21, 22... is actively controlled, whereas a contact pressure of other upper nip roller pairs 22 and the lower nip roller pairs 23 is taken as a preset constant value and the lifting force and pull-down force act passively, and such a configuration is advantageous for conducting highly effective substrate position control in a simpler manner. In the manufacturing apparatus 100 of the example shown in the figure, one upper nip roller pair 21 on the upstream side, in the conveying direction, of the film forming unit 41(f) positioned almost in the center of the conveying span is configured so that a contact pressure can be controlled with the object of actively controlling the position of the flexible substrate 1 in the vertical width direction.

In the preferred embodiment, the controllable upper nip roller pair 21 is configured by adding a control mechanism (contact pressure adjusting unit) to an assembly common with the other upper nip roller pair 22 and lower nip roller pair 23. The angle adjusting means 7 is shared by the nip roller pairs 21, 22, and 23. Depending on the system of applying a contact pressure to a roller pair, the following three basic embodiments of the control mechanism of the upper nip roller pair 21 are possible: a direct system (5), a balance system (8), and a toggle spring system (105).

### (First Embodiment)

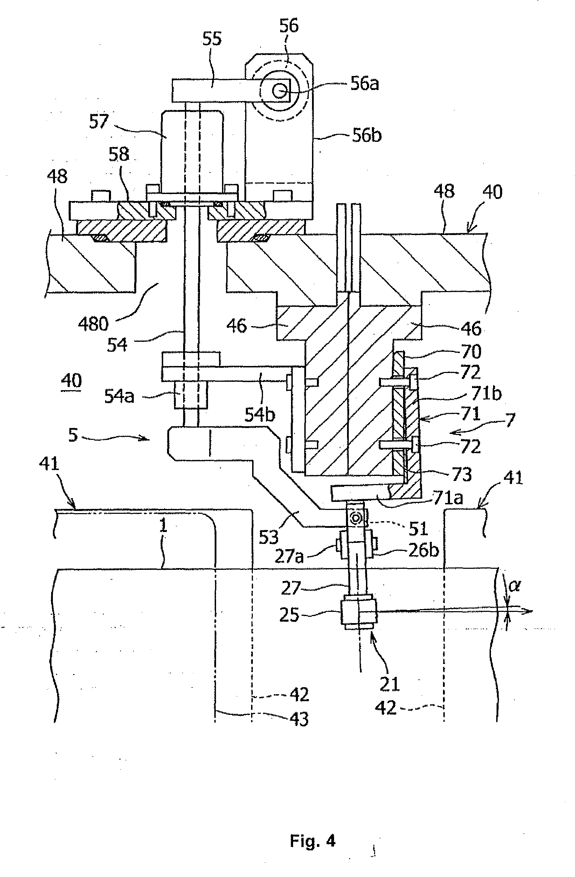

FIG. 4 and FIG. 5 show the upper nip roller pair 21 and the control mechanism 5 thereof of the first embodiment of the present invention. The control mechanism 5 is of a direct system in which a biasing force of a biasing member (51) is directly controlled. The first embodiment of the present invention will be explained below with reference to the appended drawings.

In the drawings, the upper nip roller pair 21 is composed of a pair of nip rollers 24, 25. As shown in FIG. 5, the fixed roller 24 is rotatably supported via a bearing on a support shaft 26a provided on a distal end (lower end) of a fixed support member 26 and is constituted by a metal roller body 24a and a heat-resistant rubber coating 24b coated on the circumferential of the roller body. The movable roller 25 is also rotatably supported in a similar manner at the distal end (lower end) of a movable support member 27 and is likewise constituted by a metal roller body 25a and a heat-resistant rubber coating 25b coated on the circumferential of the roller body.

As shown in FIG. 4, the fixed support member 26 is fixed at the proximal end (upper end) thereof to a bracket 71 constituting the angle adjusting means 7. The bracket 71 has a support portion 71a perpendicular to the axial direction of the fixed roller 24 and a base portion 71b expending upward and perpendicular with respect to the support portion 71a from one side of the support portion 71a. The proximal end portion of the fixed support member 26 is fixed to the support portion 71a. Further, a shim 73 is introduced between the base portion 71b of the bracket 71 and a fixed plate 70, and the base portion 71b is fixed to the vertical surface of the main structural member 46 with a bolt 72. As a result, the attachment angle of the bracket 71, that is, the attachment angle of the fixed roller 24 supported on the fixed support member 26, can be changed according to the thickness and/or number of the shims 73.

As shown in FIG. 5, the movable support member 27 is swingably supported in the intermediate portion thereof via a shaft 27a at the distal end of a bracket 26b fixedly attached to the fixed support member 26, and where the movable support member 27 is swung about the shaft 27a as a center, the movable roller 25 is brought into contact with the fixed roller 24 or withdrawn therefrom.

The movable support member 27 has an arm portion 27b that is crank-like curved from the intermediate portion (27a) and extends upward, and a retainer bar 51a for supporting a spring 51 is fixed by a nut 51b to the distal end of the arm portion 27b. The retainer bar 51a extends from the arm portion 27b in the direction crossing the axial direction of the fixed roller 24 towards the proximal end of the fixed support member 26 and is inserted into an engagement hole 53a of an operation arm 53 in a state in which a spring 51 is introduced between the retainer bar and a distal end (53a) of the below-described operation arm 53. Further, the distal end of the retainer bar 51a is inserted in an elongated hole 26c provided in the proximal end of the fixed support member 26.

The spring 51 is a compressive spring. The arm portion 27a of the movable support member 27 is biased by the spring 51 in the direction of withdrawing from the operation arm 53, and the movable roller 25 positioned on the side opposite that of the arm portion 27a with respect to the shaft 27a as a center is pressed against the fixed roller 24. Therefore, the operation arm 53 is displaced along the retainer bar 51a and the support point of the spring 51 is displaced, thereby making it possible to control the biasing force of the spring 51 and adjust the contact pressure of the nip rollers 24, 25.

The operation arm 53 is fixed at the proximal end thereof to a lower end of the rotating shaft 54. The rotating shaft 54 is rotatably supported by a bearing 54a fixed by a bracket 54b to the main structural member 46, and the upper end of the rotating shaft passes through the top section (48) of the chamber structural unit 40 via a seal bearing 57 and is joined to an output shaft 56a of the actuator 56 (linear actuator), with a lever 55 being interposed therebetween, on the outside of the vacuum chamber (40).

As described hereinabove, the upper and lower nip roller pairs 21, 22, 23 are attached to the main structural member 46 positioned between the film forming units 41, so that the angle adjusting means 7 is disposed between the roller pairs and the main structural member. Since the attachment position represents a joining portion of the adjacent chamber structural units 40, as shown in FIG. 3 or FIG. 4, the rotating shaft 54 and the seal bearing 57 are provided above the film forming units 41 over the main structural member 46. Therefore, the operation arm 53 is crank-like bent above the film forming units 41, extends below the main structural member 46, and engages with one end of the spring 51.

The seal bearing 57 is air-tightly attached to an opening 480 of the top panel 48, with a base plate 58 or an O-ring being interposed therebetween, and a bearing and a magnetic seal are provided inside the housing thereof. The rotating shaft 54 is thus rotationally supported in a state in which a difference in pressure is maintained between the inside and outside of the vacuum chamber, and the drive of the actuator 56 can be transmitted into the vacuum chamber (40) via the rotating shaft 54. The opening 480 where the seal bearing 57 and the rotating shaft 54 are not disposed has a transparent member such as a heat-resistant glass mounted thereon and serves as an observation window for observing the inside of the vacuum chamber.

Since the actuator 56 is provided outside the chamber structural unit 40 (vacuum chamber), an actuator of any system can be used. In the example illustrated by the figures, a linear actuator that converts the rotation of a servo motor into linear reciprocating motion with a screw feed mechanism or the like is used, but it is also possible to rotate the drive shaft 54 directly or indirectly by using a rotary actuator. The actuator 56 is linearly or rotationally driven by a control signal outputted from the control unit 50 on the basis of the detection value of the sensor 49.

As shown in FIG. 3, the sensor 49 is attached to the main structural member 46 adjacently to the upper nip roller pair 22 of a constant contact pressure type in a space between the film forming units 41 that is shifted downstream (or upstream) in the conveying direction by one unit with respect to the space between the film forming units 41 where the controllable upper nip roller pair 21 has been disposed. A well-known position sensor such as a reflective or transmissive optical sensor that can detect in a contactless manner the upper end portion (position in the vertical width direction) of the flexible substrate 1 can be used as the sensor 49.

The upper nip roller pair 22 of a constant contact pressure type and the lower nip roller pairs 22 can be also configured by inserting a spacer mating with the retainer bar 51a, instead of the operation arm 53, between the spring 51 and the fixed support member 26 of the upper nip roller pair 21. Further, the variation of the attachment angle of the nip roller pairs 21, 22, and 23 caused by the angle adjustment means 7 can be absorbed between the engagement hole 53a of the operation arm 53 and the retainer bar 51a.

The transverse position control of the flexible substrate 1 based on the first embodiment will be explained below.

Referring to FIG. 1, the flexible substrate 1 is intermittently conveyed at the predetermined cycle time from the unwinding unit 10 via the film forming section 20 to the winding unit 30. Thus, in the conveying period of the intermittent conveying cycle of the flexible substrate 1, the movable chambers 43 of the film forming units 41 in the film forming section 20 are withdrawn from the fixed chambers 42, the unwinding feed roller 12 and the winding feed roller 32 are synchronously driven, the flexible substrate 1 is conveyed by one unit between the movable chamber 43 and the fixed chamber 42 of each film forming unit 41, and the flexible substrate 1 is accordingly unwound from the unwinding roll 11 and wound on the winding roll 31.

In this case, the film tension of the flexible substrate 1 between the upstream and downstream guide rollers 14, 34 of the film forming section 20 is maintained constant by the tension detection rollers 13b and 33b, the position of the flexible substrate 1 in the vertical width direction in the downstream guide roller 34 is controlled to a constant value by the side end position control roller 35, and the upper edge portion and lower edge portion of the flexible substrate 1 are nipped by the nip rollers 21, 22, 23... constituting the substrate position control device between the film forming units 41 of the film forming section 20, whereby the flexible substrate 1 is prevented from sagging under gravity and the occurrence of wrinkles is inhibited by the extension in the widthwise direction. However, as described above, since the conveying span between the guide rollers 14, 34 is large and physical properties of the flexible substrate 1 in the conveying direction are not uniform, the position of the flexible substrate 1 in the vertical width direction can shift in the vertical direction.

The sensor 49 provided downstream of the substantially central film forming unit 41(f) detects the upper end position (position in the vertical width direction) of the flexible substrate 1 in parallel with the process in which the conveying of the flexible substrate 1 by one unit is completed, the film forming chambers (43, 42) of each film forming unit 41 are closed, and film formation is performed in the stop period of the conveying cycle. When a significant shift occurs upward or downward from a reference line, the detection value corresponding to the shift direction or shift amount is acquired by the control unit 50, and the control unit 50 drives back and forth the actuator 56 and adjusts the contact pressure (nipping pressure) of the upper nip roller 21 on the basis of the detection value.

For example, when the upper end of the flexible substrate 1 is detected by the sensor 49 to have been shifted significantly downward, the output shaft 56a of the actuator 56 is moved forward correspondingly to the shift amount, as shown in FIG. 4 and FIG. 5. As a result, the lever 55 rotates in response to the advance of the output shaft 56a, the rotation of the lever 55 is transmitted via the rotating shaft 54 to the operation arm 53, the support point (53a) of the spring 51 is shifted by the rotation of the operation arm 53 toward the arm portion 27b of the movable support member 27, and the biasing force of the spring 51, that is, the contact pressure (nipping pressure) of the upper nip roller 21, increases.

The film forming process in the film forming units 41 is then ended, the film forming chambers (43, 42) are opened, the unwinding feed roller 12 and the winding feed roller 32 are then synchronously rotated, and the flexible substrate 1 is conveyed by one unit between the movable chamber 43 and the fixed chamber 42 of each film forming unit 41.

Thus, where the conveying is performed, while nipping the upper and lower edges of the flexible substrate 1, in a state in which the contact pressure (nipping pressure) of the upper nip rollers 21 has been increased with respect to that of the lower nip rollers 23 having a constant contact pressure upstream of the substantially central film forming unit 41(f), the lifting force created by the upper nip rollers 21 exceeds the pull-down force created by nipping by the lower nip rollers 23, the flexible substrate 1 moves accordingly upward, and the downward shift of the flexible substrate 1 is corrected.

Where the one-unit conveying of the flexible substrate 1 is ended, the film forming chambers (43, 42) of each film forming unit 41 are closed again and the next film forming process is performed. In parallel with this process, the upper end position of the flexible substrate 1 is detected by the sensor 49 in the same manner as described above, and the contact pressure of the upper nip roller 21 is further adjusted. When an upward shift of the upper end of the flexible substrate 1 is detected by the sensor 49, where the contact pressure of the upper nip roller 21 is reduced by operations reversed with respect to the above-described ones, the flexible substrate 1 moves downward and the upward shift of the flexible substrate 1 is corrected.

Since the detection of the position in the vertical width direction and the adjustment of contact pressure that are performed in parallel with the film forming process in the stop periods of the conveying cycle are thus executed alternately with the correction of the widthwise position using the conveying force in the conveying period, the position of the flexible substrate 1 in the vertical width direction is maintained at a constant level or within a predetermined tolerance range. Further, the position in the vertical width direction can be monitored and the nipping pressure can be corrected in the conveying period.

In the present embodiment, a case is described in which the film forming process is implemented by the film forming units 41 in the conveying stop periods, while conveying the flexible substrate 1 intermittently in a step-wise manner. However, the present invention is not limited to such a process and can be also implemented when film formation is performed, while continuously conveying the flexible substrate in the common vacuum chamber. In this case, the position of the flexible substrate 1 in the vertical width direction can be maintained at a constant level or within a predetermined tolerance range by executing the control of nipping pressure, while constantly monitoring the position of the flexible substrate in the vertical width direction with a sensor.

### (Second Embodiment)

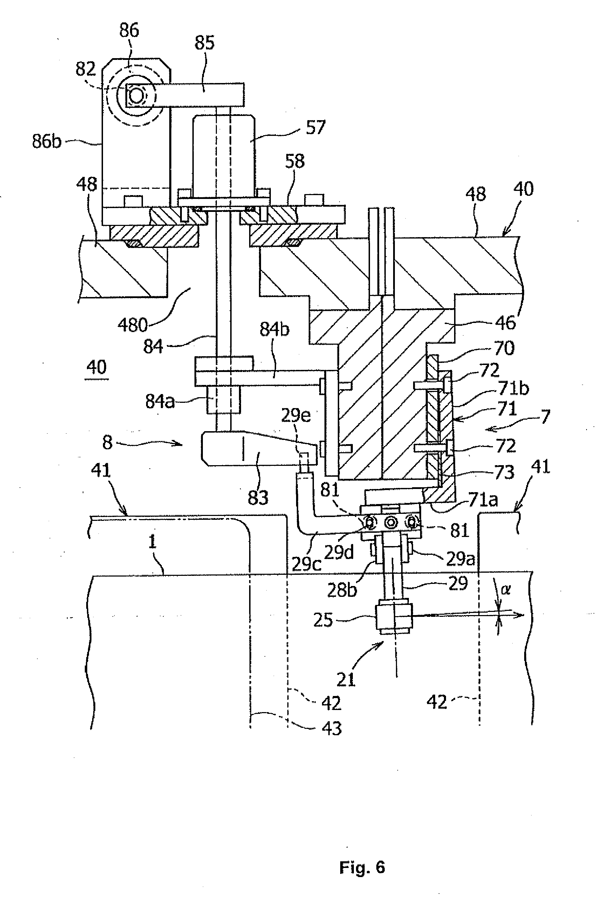

FIG. 6 to FIG. 8 illustrate the upper nip roller pair 21 and the control mechanism 8 thereof according to the second embodiment of the present invention. The control mechanism 8 is of a balance system in which a contact pressure is controlled by balancing the biasing force of a first biasing member (81) and the biasing force (adjusting force) of a second biasing member (82). Since the basic structure of the upper nipping roller pair 21 is similar to that of the above-described first embodiment, like members are assigned with like reference numerals and explanation thereof is herein omitted. The explanation of the second embodiment presented below with reference to the appended drawings is focused on the difference between the two embodiments.

The second embodiment is similar to the first embodiment in that the upper nip roller pair 21 is composed of a pair of nip rollers 24, 25 and the fixed support member 28 rotatably supporting the fixed roller 24 is fixed to the bracket 71 constituting the angle adjusting means 7 and also in that the movable support member 29 rotatably supporting the movable roller 25 is swingably supported in the intermediate portion thereof by the shaft 29a at the distal end of the bracket 28b fixed to the fixed support member 28. However, in the second embodiment, the upper end 29b of the movable support member 29 is biased in the direction of withdrawing from the base portion of the fixed support member 28 and the movable roller 25 is pressed against the fixed roller 24 by a spring 81 inserted between an extension arm 29c fixed to the upper end 29b of the movable support member 29 and an expansion piece portion 28c of the bracket 28b fixedly attached to the fixed support member 28. The support point of the spring 81 is fixed and does not change.

The extension arm 29c extends transversely by crossing the upper end portion of the movable support member 29 and is fixed by a bolt to the upper end portion 29b in the crossing zone, long holes 29d, 29d being drilled at both sides of the fixing portion. As shown in FIG. 8, retainer bars 81a, 81a for supporting the springs 81, 81 are fixed by nuts 81b, 81b at the expansion piece portions 28c, 28c protruding at both sides of the fixed support member 28. The springs 81, 81 are compressive springs, and distal end portions of the retainer bars 81a, 81a that support the springs 81, 81 are inserted into the long holes 29d, 29d of the extension arm 29c, with the respective washers being interposed therebetween, and the biasing forces of the springs 81, 81 are applied to the side of the extension arm 29c.

One arm portion of the extension arm 29c is extended to the film forming unit 41 side, bent to bypass the main structural member 46, extended upward, and further bent upward of the flexible substrate 1. A pin 29e engageable with a distal end of an operation arm 83 is provided in a vertical condition at the upper end portion of the extension arm.

The operation arm 83 is fixed at the proximal end thereof to the lower end of a rotating shaft 84. The rotating shaft 84 is rotationally supported by a bearing 84a fixed by a bracket 84b to the main structural member 46, and passes through the top section (48) of the chamber structure unit 40 via the seal bearing 57, in the same manner as in the configuration of the first embodiment. A lever 85 is attached to the upper end of the rotating shaft 84 positioned outside the vacuum chamber (40).

An engagement hole 85a (long hole) is drilled in the distal end portion of the lever 85. The distal end portion of a retainer bar 82a supporting a spring 82 is inserted into the engagement hole 85a, and the biasing force (adjusting force) of the spring 82 acts upon the distal end portion of the lever 85. The retainer bar 82a is joined to an output shaft 86a of an actuator 86 (linear actuator) and moves back and forth together with the output shaft 86a.

In the control mechanism 8 of the upper nip roller pair 21 having the above-described configuration, similarly to the above-described first embodiment, the actuator 86 is linearly driven by a control signal outputted from the control unit 50 on the basis of the detection value of the sensor 49, and the biasing force of the spring 82 corresponding to the movement amount of the actuator is applied to the distal end portion of the lever 85. This biasing force is converted by the lever 85 into a torque, transmitted to the operation lever 83 by the rotating shaft 84, and serves as an adjusting force applying a pressure, via the pin 29e, to the extension arm 29c against the biasing forces of the springs 81, 81. The biasing forces of the springs 81, 81 are canceled by this adjusting force and the contact pressure (nipping pressure) of the upper nip roller pair 21 is adjusted.

Therefore, in the control mechanism 8 of the second embodiment, the biasing force of the spring 81 is applied at all times to the upper nip roller pair 21 via the extension arm 29c and the movable support member 29. In particular, in a region in which the contact pressure (nipping pressure) of the upper nip roller pair 21 is small, that is, in a region in which the displacement in the vertical width direction is small and the control of the widthwise position converges, the biasing force of the spring 81 and the biasing force (adjusting force) of the spring 82 increase and excellent control accuracy and stability are attained.

Further, the upper nip roller pair 21 of the second embodiment can be used directly, or after cutting off one arm portion of the extension arm 29c that includes the pin 29e, as the other nip roller pairs 23, 23 of a constant contact pressure type, so that the support point of the spring 81 constitute a nip roller assembly independent from the control mechanism 8. The change in the attachment angle of the nip roller pairs 21, 22, 23 caused by the angle adjusting means 7 can be absorbed between the pin 29e and the operation arm 83.

### (Variation Examples of the First and Second Embodiments)

Two basic embodiments of the present invention are described above, but several other variation examples with different arrangements of the springs 51, 81, 82 can be considered. In the variation examples, the members similar to those of the above-described embodiments will be assigned with similar reference numerals and explained schematically.

FIG. 9 is a schematic diagram illustrating a variation example of the first embodiment in which a direct-type control mechanism 5" is additionally provided in the upper nip rollers 24, 25. In this configuration, a spring 51' is disposed outside the vacuum chamber, the support point of the spring 51' is shifted linearly by a reciprocal drive of the actuator 56, the controlled biasing force of the spring 51' is transmitted to the movable support member 27 inside the vacuum chamber via a lever 55', a rotating shaft 54', and an operation arm 53' constituting a biasing force transmission mechanism, and the contact pressure (nipping pressure) of the upper nip rollers 24, 25 is adjusted.

FIG. 10 is a schematic diagram illustrating a variation example of the second embodiment in which a balance-type control mechanism 8' is additionally provided in the upper nip rollers 24, 25. In this configuration, the spring 81 and a spring 82¹ are both disposed inside the vacuum chamber. The spring 81 biases the movable support member 27 with respect to a fixing point (28) in the same manner as described above, and applies a contact pressure to the movable roller 25. The spring 82¹ biases the movable support member 27 with respect to the operation arm 83' in the direction opposite that of the biasing force of the spring 81. The reciprocal drive of the actuator 86 is transmitted to the support point of the spring 82¹ inside the vacuum chamber via a lever 85', a rotating shaft 84', and an operation arm 83' constituting a drive transmission mechanism, the biasing force (adjusting force) of the spring 82¹ is controlled in response to the displacement of the support point, and the biasing force of the spring 81 is reduced accordingly, whereby the contact pressure (nipping pressure) of the upper nip rollers 24, 25 is adjusted.

FIG. 11 is a schematic diagram illustrating another variation example of the second embodiment in which a balance-type control mechanism 8" is additionally provided in the upper nip rollers 24, 25. In this configuration, a spring 81¹ and the spring 82 are both disposed outside the vacuum chamber. The spring 81' biases the lever 85" with respect to a fixed point, and the spring 82" biases a lever 85" with respect to the output shaft of the actuator 86 in the direction opposite that of the spring 81'. The biasing force (adjusting force) of the spring 82¹ is controlled in response to the reciprocal drive of the actuator 86, the biasing force of the spring 81' is reduced accordingly, and the controlled biasing force is transmitted to the movable support member 27 inside the vacuum chamber via the lever 85", a rotating shaft 84", and an operation arm 83" constituting a biasing force transmission mechanism, whereby the contact pressure (nipping pressure) of the upper nip rollers 24, 25 is adjusted.

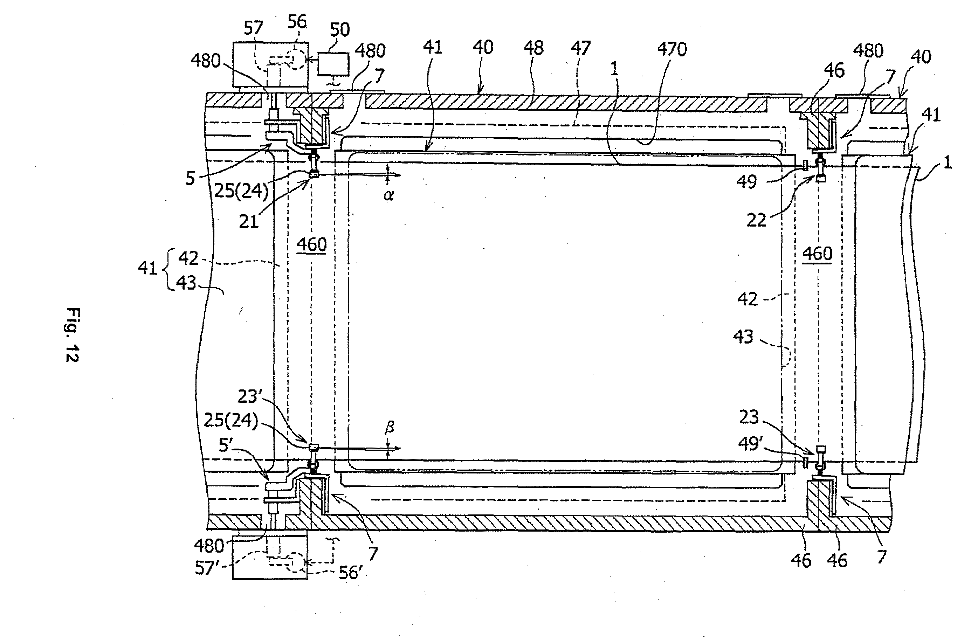

In the above-described embodiments, the case is described in which the contact pressure of the upper nip roller pair 21 is actively controlled, but the contact pressure of the opposing lower nip roller pair 23 is a preset constant value. However, as shown in FIG. 12, a configuration is also possible in which the contact pressure of the upper and lower nip roller pairs 21, 23¹ located in the same position with respect to the conveying direction is actively controlled.

In the example shown in FIG. 12, the control mechanism 5' (contact pressure adjusting unit) similar to that of the upper nip roller pair 21 is additionally provided, with a reversal in the vertical direction, in the lower nip roller pair 23' that is located in the same position with respect to the conveying direction as the upper nip roller pair 21 according to the first embodiment, and a sensor 49' that detects the position of the lower edge portion of the flexible substrate 1 is also additionally provided. The detection values of the upper and lower sensors 49, 49' are sent to the common control unit 50, and the control unit 50 drives the upper and lower actuators 56, 56' and controls the contact pressure of the upper and lower nip roller pairs 21, 23¹ on the basis of these detection values.

Thus, the control unit 50 can acquire the position of the flexible substrate 1 in the vertical width direction and the extension degree of the flexible substrate 1 on the basis of the detection values of the upper and lower sensors 49, 49' and control the contact pressure of the upper and lower nip roller pairs 21, 23¹ on the basis of the acquired data, whereby the position in the vertical width direction can be maintained at a constant level or within a predetermined tolerance range, while maintaining the extension degree of the flexible substrate 1 within a predetermined range.

When the contact pressure of the lower nip roller pair 23 is set in advance to a constant value, the contact pressure of the upper nip roller pair 21 is controlled within a range of values greater than the contact pressure of the lower nip roller pair 23, but as described hereinabove, by enabling active control of the contact pressure of the upper and lower nip roller pairs 21, 23¹, it is possible to control the contact pressure of the upper and lower nip roller pairs 21, 23' in a region with a small contact pressure within a wide range including zero. The above-described configuration can be also applied to the lower nip roller pair of the second embodiment.

### (Third Embodiment)

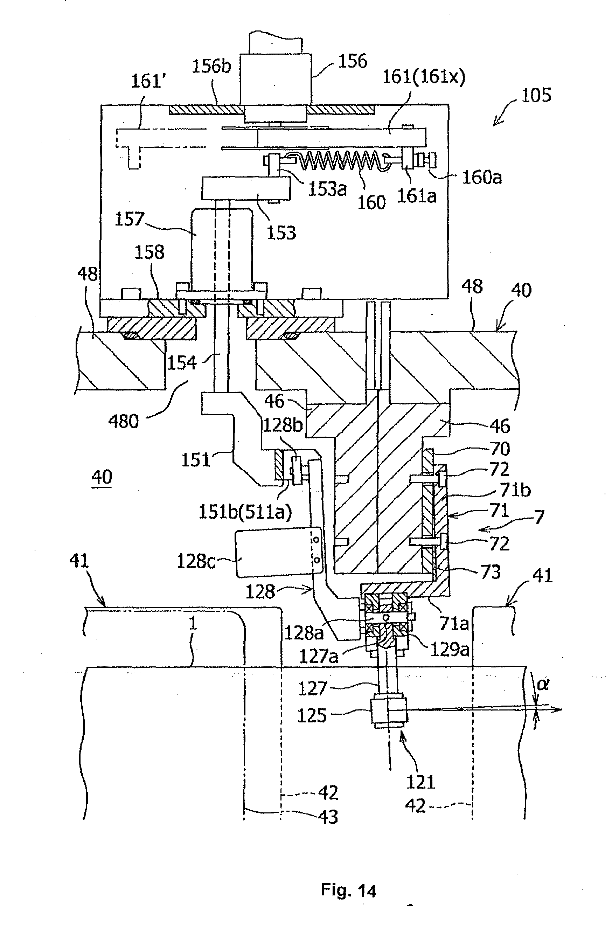

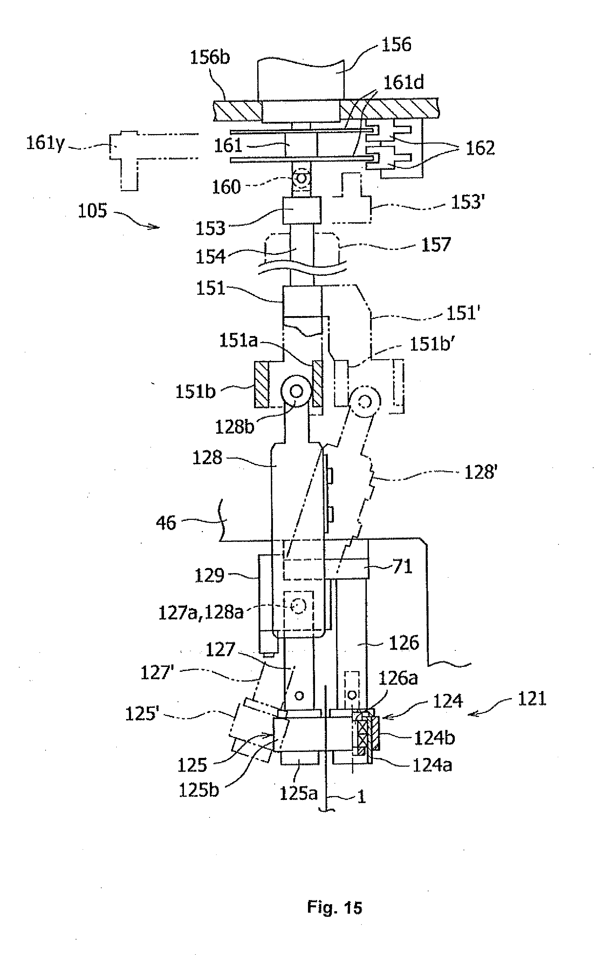

FIGS. 14 to 16 illustrate an upper nip roller pair 121 and a control mechanism 105 thereof (contact pressure adjusting unit) of the third embodiment of the present invention. The upper nip roller pair 121 is composed of a pair of nip rollers 124, 125. As shown in FIG. 15, the fixed roller 124 is constituted by a metal roller body 124a rotatably supported by a bearing on a support shaft 126a provided at a distal end (lower end) of a fixed support member 126, and a heat-resistant rubber coating 124b coated on the circumferential surface of the roller body. The movable roller 125 is also constituted by a metal roller body 125a rotatably supported in a similar manner at a distal end (lower end) of a fixed support member 127, and a heat-resistant rubber coating 125b coated on the circumferential surface of the roller body.

As shown in FIG. 14, the fixed support member 126 is fixed at the proximal end portion (upper end portion) thereof to a bracket 71 constituting the angle adjusting means 7. The bracket 71 has a support portion 71a that is perpendicular to the axial direction of the fixed roller 124 and a base portion 71b that extends from one side of the support portion 71a upward in the direction perpendicular to the support portion 71a. The proximal end portion of the fixed support member 126 is fixed to the support portion 71a. The proximal end portion of the fixed support member 126 is fixed to the support portion 71a. Further, a shim 73 is introduced between the base portion 71b of the bracket 71 and the fixed plate 70, and the proximal end 71b is fixed to the vertical surface of the main structural member 46 with a bolt 72. As a result, the attachment angle of the bracket 71, that is, the attachment angle of the fixed roller 124 and the movable roller 125 constituting the nip roller pair 121 can be changed according to the thickness and/or number of the shims 73.

As shown in FIG. 14, a shaft 128a of an extension arm 128 that is rotatably supported via a bearing on a pair of support portions 129a, 129a of the bracket 129 fixedly attached to the support portion 71a of the bracket 71 is passed through a transverse hole 127a of the proximal end portion (upper end portion) in the intermediate zones of the support portions 129a, 129a, and intersection portions thereof are fixed with a stop screw. As a result, as shown in FIG. 15, the movable support member 127 is supported integrally with the extension arm 128 so that the two components can swing about the shaft 128a as a center, and the movable roller 125 can be brought into contact with the fixed roller 124 or withdrawn therefrom.

The extension arm 128 is extended upward from one end portion of the shaft 128a, while bending so as to bypass the main structural member 46, and a roller 128b that is engaged with the distal end portion (151a) of a second arm 151 is rotatably supported on a support shaft provided in a condition of protruding parallel to the shaft 128a at the upper end portion of the extension arm. An operation plate 128c serving as an operation lever for the below-described release operation is fixedly attached to the intermediate portion of the extension arm 128.

The second arm 151, together with the below-described rotating shaft 154 and first arm 153, constitutes a transmission mechanism and is fixed at the proximal end portion thereof to the lower end of the rotating shaft 154.
As shown in FIG. 15, two engagement portions 151a, 151b that can engage from both directions in swinging with the roller 128b of the extension arm 128 are provided at the distal end portion of the second arm 151.

The first engagement portion 151a is a pressurization engagement portion for pressing the movable roller 125 against the fixed roller 124. In the example shown in the figure, the second arm 151 and the below-described first arm 153 are oriented in the conveying direction of the flexible substrate 1, and when the engagement portion 151a abuts on the roller 128b, the movable roller 125, the movable support member 127, and the extension arm 128 are oriented in the vertical direction and the movable roller 125 abuts on the fixed roller 124.

The second engagement portion 151b is a release engagement portion for withdrawing the movable roller 125 back from the fixed roller 124. The second engagement portion 151b is disposed opposite the first engagement portion 151a, with the gap therebetween being somewhat larger than the diameter of the roller 128b, in order to enable together with the roller 128b the transmission of an angular displacement, while absorbing the difference in swinging trajectories between the second arm 151 and the extension arm 128 swingably supported on shafts (154, 128a) that are almost perpendicular to each other.

The rotating shaft 154 is air-tightly and rotatably supported by a seal bearing 157, passes through the top panel 48 of the chamber structure unit 40 via the seal bearing 157, and extends upward. The first arm 153 is fixed to the upper end portion of the rotating shaft 154 positioned outside the vacuum chamber (40). The seal bearing 157 is air-tightly attached to the opening 480 of the top panel 48, with a base plate 158 or an O-ring being interposed therebetween, and a bearing and a magnetic seal are provided inside the housing thereof. The rotating shaft 154 is thus rotationally supported in a state in which a difference in pressure is maintained between the inside and outside of the vacuum chamber. The other opening 480 where the seal bearing 157 and the rotating shaft 154 are not disposed has a transparent member such as a heat-resistant glass mounted thereon and serves as an observation window for observing the inside of the vacuum chamber.

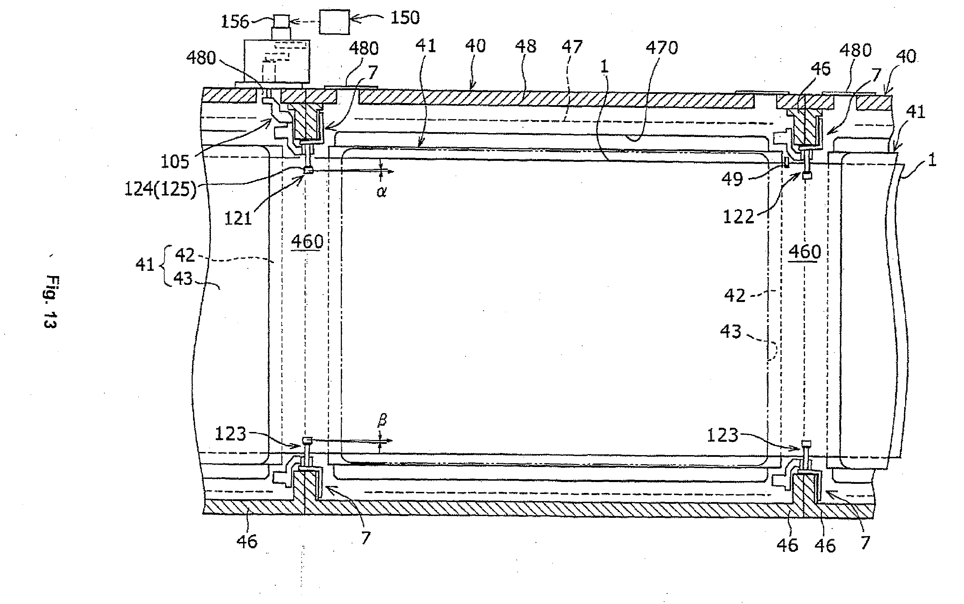

As described hereinabove, the upper and lower nip roller pairs 121, 122, 123 are attached, with the angle adjusting means 7 being interposed therebetween, to the main structural members 46 disposed between the film forming units 41, and because the attachment positions thereof are the joint portions with the adjacent chamber structure units 40, the rotating shaft 154 and the seal bearing 157 are provided above the film forming units 41 to avoid the main structural members 46, as shown in FIG. 13 and FIG. 14. For this purpose, the second arm 151 is bent in a crank-like shape from the lower end portion of the rotating shaft 154, extends to the vicinity of the main structural member 46, and engages with the roller 128b of the extension arm 128 in the engagement portions 151a, 151b.

The connecting pin 153a is provided in a condition of extending upward at the distal end portion of the first arm 153. The connecting pin 153a is supported by a bearing so that the pin can rotate about an axis parallel to the rotating shaft 154 in a support hole passing through the distal end portion of the first arm 153 in the vertical direction, and one end of a spring 160 is connected to the connecting pin 153a (this configuration is not shown in the figure). The spring 160 is a tension spring, and the other end thereof is connected to a support pin 161a of a drive arm 161 by an adjusting screw 160a.

The spring 160 stretches in a pre-extended state between the connecting pin 153a of the first arm 153 and the support pin 161a of the drive arm 161, and a tension F of the spring 160 can be adjusted by adjusting the extension degree thereof with the adjusting screw 160a. The maximum value of the biasing force applying a contact pressure to the nip roller 121 is determined, as described hereinbelow, according to the tension F.

The drive arm 161 is fixed at the proximal end portion thereof to a drive shaft of the actuator 156. The support pin 161a that protrudes downward at the distal end portion of the drive arm 161 is supported, so that the support pin can rotate about an axis parallel to the drive shaft, by a bearing in a support hole passing vertically through the distal end portion of the drive arm 161, in the same manner as the connecting pin 153a. A sector plate 161d is coaxially attached to the proximal end portion of the drive arm 161, and an over-travel sensor 162 is disposed in the vicinity of the outer circumference of the sector plate 161d.

The actuator 156 is a rotary actuator such as a servo motor incorporating an encoder, and the drive shaft thereof is mounted on an upper plate 156b fixed via a support frame (not shown in the figure) above a base plate 158, so as to match the axis center and face the connecting pin 153a of the first arm 153 in the pressurization position (strictly speaking, a rotation origin point of the first arm 153 corresponding to the case in which the movable roller 125 abuts on the fixed roller 124 under a zero contact pressure).

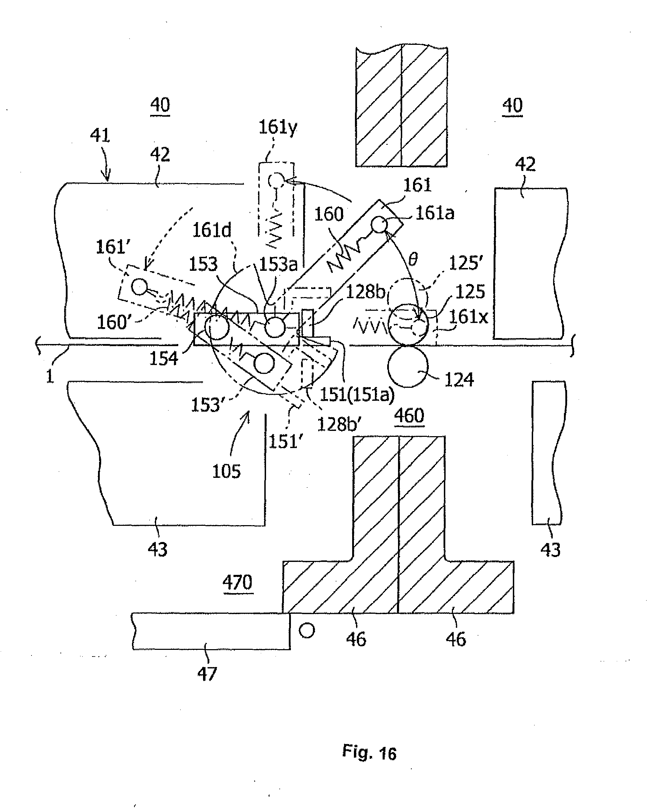

The actuator 156 is driven by a control signal outputted from the control unit 150 on the basis of the detection value of the sensor 49 shown in FIG. 13, the drive arm 161 is rotationally displaced to a predetermined angular position between a minimum pressurization position 161x (rotation origin point) and a maximum pressurization position 161y shown in FIG. 16, and a biasing force corresponding to the angular displacement of the drive arm 161 is applied to the first arm 153, as will be described hereinbelow.

Thus, referring to FIG. 16, when the drive arm 161 is oriented in the conveying direction of the flexible substrate 1, aligned on the same line with the first arm 153 located in a pressurization position, and located in the minimum pressurization position 161x in which the angular displacement is zero, the orthogonal component (Fy = F·sinθ) of the tension F of the spring 160 that rotates the first arm 153 counterclockwise (as shown in the figure) from this position is zero and the biasing force that rotates the first arm 153 counterclockwise (as shown in the figure) about the rotating shaft 154 does not act. In such minimum pressurization position 161x, the tension F of the spring 160 acts as a component (Fx = F·cosθ) holding the first arm 153 in the pressurization position (rotation origin point).

Where the drive arm 161 is rotated from this state to an angular displacement θ shown by a solid line in the figure, the orthogonal component (Fy = F·sinθ) of the tension F of the spring 160 corresponding to the angular displacement θ acts as a biasing force rotating the first arm 153 counterclockwise (as shown in the figure). This biasing force Fy is transmitted via the rotating shaft 154 to the second arm 151, the roller 128b is biased upward (as shown in the figure) via the first engagement portion 151a, and the extension arm 128 and the movable support member 127 are biased counterclockwise, as shown in FIG. 15, about the shaft 128a. As a result, the movable roller 125 is pressed against the fixed roller 124 by a pressurizing force obtained by multiplying the biasing force Fy by a lever ratio.

Where the drive arm 161 is then rotated to the maximum pressurization position 161y (angular displacement θ = 90°) orthogonal to the first arm 153 located in the pressurization position, the entire tension F of the spring 160 acts as a biasing force rotating the first arm 153 counterclockwise (as shown in the figure) about the rotating shaft 154 and the movable roller 125 is pressed against the fixed roller 124 by a pressurizing force obtained by multiplying the tension F of the spring 160 by a lever ratio.

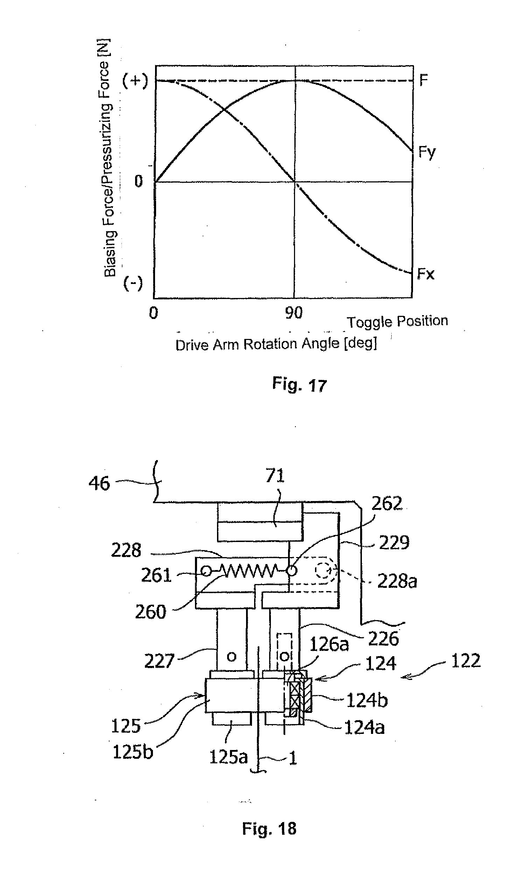

FIG. 17 shows the relationship between the angular displacement θ of the dive arm 161, tension F of the spring 160, biasing component Fy, and component Fx orthogonal to the biasing direction. As shown in FIG. 17, within the rotation range of the drive arm 161 from the minimum pressurization position 161x (rotation origin point) to the maximum pressurization position 161y, the tension F of the spring 160 is constant and the drive force is consumed on elastically deforming the spring 160 itself. Therefore, a large drive force is not required for the control. Furthermore, since no effect is provided by friction accompanying the elastic deformation of the spring 160, high-accuracy control can be performed. The additional advantage is that even in a region in which the angular displacement θ of the drive arm 161 is small and the contact pressure of the nip roller pairs 124, 125 decreases, the position of the first arm 153 is stabilized by the component Fx of the spring tension F that is orthogonal to the biasing direction and a stable pressurization state of the nip roller pairs 124, 125 can be obtained.

Since the actuators 156 is provided outside the chamber structure unit 40 (vacuum chamber), an actuator of any system can be used. For example, a configuration can be also used in which the drive arm 161 is a swinging arm of the same layout, a linear actuator is connected directly or via a link to the swinging arm, and the swinging arm (161) is angularly displaced by a reciprocating motion of the linear actuator.

As shown in FIG. 13, the sensor 49 is attached to the main structural member 46 adjacently to the upper nip roller pair 122 of a constant contact pressure type in a space between the film forming units 41 that is shifted upstream in the conveying direction by one unit with respect to the space between the film forming units 41 where the controllable upper nip roller pair 121 has been disposed. For example, a well-known position sensor such as a reflective or transmissive optical sensor that can detect in a contactless manner the upper end position (position in the vertical width direction) of the flexible substrate 1 can be used as the sensor 49.

As shown in FIG. 18, the upper nip roller pair 122 of a constant contact pressure type has a configuration such that a movable support member 227 is fixedly attached to the distal end of an arm portion 228 rotatably supported via a shaft 228a on a bracket 229 of a fixed support member 226, a spring 260 is inserted in a pre-extended state between a support pin 261 provided at the arm portion 228 and a support pin 262 provided at the bracket 229, and the movable roller 125 is pressed against the fixed roller 124 with a predetermined pressure by a biasing force of the spring 260. One of the support pins 261, 262 is connected to the end portion of the spring 260 by a tension adjusting means similar to the above-described adjusting screw 160a (this feature is not shown in the figure). In the lower nip roller pair 123 of a constant contact pressure type and the upper nip roller pair 122, the arrangement of common units is reversed in the vertical direction.

The upper nip roller pair 122 (and the lower nip roller pair 123) in the example shown in the figure are set such that in a state in which the movable roller 124 is pressed against the fixed roller 124 and the flexible substrate 1 is nipped therebetween, the support pins 261, 262 on both sides of the spring 260 and the shaft 228a of the arm portion 228 are positioned substantially on the same straight line, and the shortest distance between the support pins 261, 262, that is, the shortest length of the spring 260, is attained in this state. With such a configuration, an almost constant tensile force of the spring 260 is maintained in a region in which the flexible substrate 1 is nipped by the movable roller 125 and the fixed roller 124 and the nipping pressure acting upon the flexible substrate 1 is stabilized. Therefore, the stable lifting force and pull-down force corresponding to the slight bias angles α, β of the nip roller pairs 122, 123 can be caused to act upon the upper end portion and lower edge portion of the flexible substrate 1.

The transverse position control of the flexible substrate 1 based on the third embodiment will be explained below.

Referring to FIG. 1, the flexible substrate 1 is intermittently conveyed at the predetermined cycle time from the unwinding unit 10 via the film forming section 20 to the winding unit 30. Thus, in the conveying period of the intermittent conveying cycle of the flexible substrate 1, the movable chambers 43 of the film forming units 41 in the film forming section 20 are withdrawn from the fixed chambers 42, the unwinding feed roller 12 and the winding feed roller 32 are synchronously driven, the flexible substrate 1 is conveyed by one unit between the movable chamber 43 and the fixed chamber 42 of each film forming unit 41, and the flexible substrate 1 is accordingly unwound from the unwinding roll 11 and wound on the winding roll 31.

In this case, the film tension of the flexible substrate 1 between the upstream and downstream guide rollers 14, 34 of the film forming section 20 is maintained constant by the tension detection rollers 13b and 33b, the position of the flexible substrate 1 in the vertical width direction in the downstream guide roller 34 is controlled to a constant value by the side end position control roller 35, and the upper edge portion and lower edge portion of the flexible substrate 1 are nipped by the nip rollers 121, 122, 123... constituting the substrate position control device between the film forming units 41 of the film forming section 20, whereby the flexible substrate 1 is prevented from sagging under gravity and the occurrence of wrinkles is inhibited by the extension in the widthwise direction. However, as described above, since the conveying span between the guide rollers 14, 34 is large and physical properties of the flexible substrate 1 in the conveying direction are not uniform, the position of the flexible substrate 1 in the vertical width direction can shift in the vertical direction.

The sensor 49 provided downstream of the substantially central film forming unit 41(f) detects the upper end position (position in the vertical width direction) of the flexible substrate 1 in parallel with the process in which the conveying of the flexible substrate 1 by one unit is completed, the film forming chambers (43, 42) of each film forming unit 41 are closed, and film formation is performed in the stop period of the conveying cycle. When a significant shift occurs upward or downward from a reference line, the detection value corresponding to the shift direction or shift amount is acquired by the control unit 150, and the control unit 150 drives the actuator 156, controls the angular displacement of the drive arm 161, and adjusts the contact pressure (nipping pressure) of the upper nip roller 121 on the basis of the detection value.

For example, when the upper end of the flexible substrate 1 is detected by the sensor 49 to shift significantly downward in a state in which the drive arm 161 of the actuator 156 has an intermediate angular displacement θ shown by a solid line in FIG. 16 and the contact pressure corresponding to such angular displacement is applied to the upper nip roller 121, the drive arm 161 of the actuator 156 in the configuration shown in FIG. 16 is angularly displaced towards the maximum pressurization position 161y according to the shift amount.
As a result, a biasing component Fy of the tension F of the spring 160 increases, this biasing force Fy is transmitted to the movable support member 127 via the first arm 153, the rotating shaft 154, the second arm 151, and the extension arm 128, and the contact pressure (nipping pressure) of the upper nip roller 121, increases.

The film forming process in the film forming units 41 is then ended, the film forming chambers (43, 42) are opened, the unwinding feed roller 12 and the winding feed roller 32 are then synchronously rotated, and the flexible substrate 1 is conveyed by one unit between the movable chamber 43 and the fixed chamber 42 of each film forming unit 41.

Thus, where the conveying is performed, while nipping the upper and lower edges of the flexible substrate 1, in a state in which the contact pressure (nipping pressure) of the upper nip roller 121 has been increased with respect to that of the lower nip roller 123 having a constant contact pressure upstream of the substantially central film forming unit 41(f), the lifting force created by the upper nip rollers 121 exceeds the pull-down force created by nipping of the lower nip rollers 123, the flexible substrate 1 moves accordingly upward, and the downward shift of the flexible substrate 1 is corrected.

Where the one-unit conveying of the flexible substrate 1 is ended, the film forming chambers (43, 42) of each film forming unit 41 are closed again and the next film forming process is performed. In parallel with this process, the upper end position of the flexible substrate 1 is detected by the sensor 49 in the same manner as described above, and the contact pressure of the upper nip roller 121 is further adjusted. When an upward shift of the upper end of the flexible substrate 1 is detected by the sensor 49, where the contact pressure of the upper nip roller 121 is reduced by operations reversed with respect to the above-described ones, the flexible substrate 1 moves downward in the next conveying step and the upward shift of the flexible substrate 1 is corrected.

Since the detection of the position in the vertical width direction and the adjustment of contact pressure that are performed in parallel with the film forming process in the stop periods of the conveying cycle are thus executed alternately with the correction of the widthwise position using the conveying force in the conveying period, the position of the flexible substrate 1 in the vertical width direction is maintained at a constant level or within a predetermined tolerance range. Further, the position in the vertical width direction can be monitored and the nipping pressure can be corrected in the conveying period.

In the third embodiment, a case is described in which the film forming process is implemented by the film forming units 41 in the conveying stop periods, while conveying the flexible substrate 1 intermittently in a step-wise manner. However, the present invention is not limited to such a process and can be also implemented when film formation is performed, while continuously conveying the flexible substrate in the common vacuum chamber. In this case, the position of the flexible substrate 1 in the vertical width direction can be maintained at a constant level or within a predetermined tolerance range by executing the control of nipping pressure, while constantly monitoring the position of the flexible substrate in the vertical width direction with a sensor.

### (Operations Performed During Flexible Substrate Introduction in the Third Embodiment)

Operations performed when the flexible substrate 1 is introduced in the manufacturing apparatus 100 in the third embodiment will be explained below with reference to the appended drawings.

When the pressure contact state of the nip roller pairs 124, 125 is released after the wound winding roller 31 has been unloaded and before the flexible substrate 1 is introduced, a release signal is outputted from the control unit 150 to the actuator 156 by operating a release switch (not shown in the figure) or the like and the drive arm 161 is angularly displaced to a toggle position 161' over the maximum pressurization position 161y, as shown by a two-dot-dash line in FIG. 16.

In the toggle position 161', the support point (161a) of the spring 160 is on the pressurization side with respect to the connection point (153a) of the first arm 153, and under the effect of the biasing component Fy of the spring tension F, the upper nip roller pair 121 is held in the pressure contact state and a standby angle of about 15° is left with respect to a dead center of the toggle mechanism on a line joining the support point (161a) and the rotating shaft 154.

Referring to FIG. 1, the untreated unwinding roll 11 is mounted on an unwinding device, and the flexible substrate 1 pulled out from the unwinding roll 11 is wound on the tension detection rollers 13a, 13b, unwinding feed roller 12, and guide roller 14 and introduced in the film forming units 41 of the film forming section 20. Where side walls 47 of the chamber structure units 40 shown in FIG. 2 and FIG. 13 are open when the flexible substrate 1 is introduced into the film forming section 20, the high-frequency voltage 45 attached to the side wall 47 and the movable chamber 43 are moved to the outside the chamber structure unit 40, the fixed chamber 42 containing the ground electrode 44 is exposed inside the opening 470, and the upper nip roller pairs 121, 122... and lower nip roller pairs 123, 123... attached above and below the opening 460 in the joining portions of the chamber structure units 40 can be accessed.

Where the operator manually (side of the opening 470) pulls the operation plate 128c (FIG. 14) of the upper nip roller pair 121 against the biasing force (Fy) of the spring 160 in this state and rotates the extension arm 128 integrated with the operation plate 128c to a position 128' shown by a two-dot-dash line in FIG. 15, the movable support member 127' swings integrally with the extension arm 128', and the movable roller 125 is withdrawn from the fixed roller 124, as shown by 125' in the figure.

At the same time, the rotation of the extension arm 128' pushes the first engagement portion 151a of the second arm 151 via the roller 128b, the first arm 153 integrally connected by the second arm 151 and the rotating shaft 154 rotates clockwise (as shown in FIG. 16) as shown by 151' and 153', and the connecting pin 153a of the first arm 153 moves to 153' over the dead center. As a result, the biasing direction of the spring 160' with respect to the first arm 153' is reversed. Accordingly, the first arm 153' is held in the reversed position by the reversed biasing force of the spring 160' and, as shown in FIG. 14, the extension arm 128' and the movable support member 127' are constraint to the swinging position via the roller 128b by the engagement portion 151b' of the second arm 151' connected by the rotating shaft 154 to the first arm 153', and the movable roller 125' is held in the withdrawn position.

Where the operator pushes the operation plate 128c and returns the extension arm 128 and the movable support member 127 to the original position after the flexible substrate 1 has been introduced between the movable roller 125' held in the withdrawal state and the fixed roller 124, the first arm 151 that is engaged with the extension arm 128 via the roller 128b and the engagement portion 151b and the first arm 153 that is integrally connected thereto by the rotating shaft 154 rotate to the original position. As a result, the biasing direction of the spring 160 is reversed to the pressurization side, the movable roller 125 is immediately pressed against the fixed roller 124 by the biasing force of the spring 160, and the introduced flexible substrate 1 is nipped.

Since a mechanism for controlling the contact pressure is not introduced in the other upper nip roller pair 122 or the lower nip roller pairs 123, the movable roller 125 can be manually withdrawn in a comparatively easy manner and the operation of introducing the flexible substrate 1 can be implemented. However, the toggle mechanism such that holds the movable roller 125 in the withdrawal position similarly to the upper nip roller pair 121 can be also configured by using a spring (260) for pressurization.

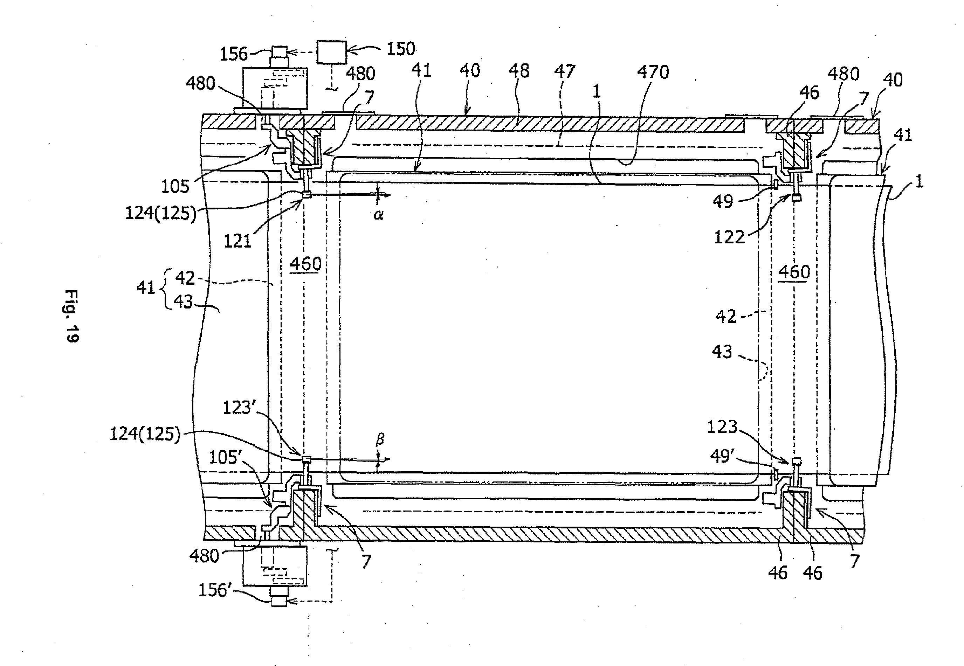

In the above-described embodiment, the case is explained in which the contact pressure of the upper nip roller pair 121 can be actively controlled, whereas the contact pressure of the corresponding lower nip roller pair 123 is a preset constant value. However, it is also possible to control actively the contact pressure of the upper and lower nip roller pairs 121, 123' located in the same positions with respect to the conveying direction, as shown in FIG. 19.

In the example shown in FIG. 19, a control mechanism 105' (contact pressure adjusting unit) similar to that of the upper nip roller pair 121 is additionally provided in a position reversed in the vertical direction at the lower nip roller pair 123' located in the same position as the upper nip roller pair 121 with respect to the conveying direction, and also the sensor 49' is additionally provided to detect the position of the lower edge portion of the flexible substrate 1. The detection values of the upper and lower sensors 49, 49' are sent to the common control unit 150, and the control unit 150 drives the upper and lower actuators 156, 156' and controls the contact pressure of the upper and lower nip roller pairs 121, 123' on the basis of these detection values.

Thus, the control unit 150 can acquire the position of the flexible substrate 1 in the vertical width direction and the extension degree of the flexible substrate 1 on the basis of the detection values of the upper and lower sensors 49, 49' and control the contact pressure of the upper and lower nip roller pairs 121, 123' on the basis of the acquired data, whereby the position in the vertical width direction can be maintained at a constant level or within a predetermined tolerance range, while maintaining the extension degree of the flexible substrate 1 within a predetermined range.

When the contact pressure of the lower nip roller pair 123 is set in advance to a constant value, the contact pressure of the upper nip roller pair 121 is controlled within a range of values greater than the contact pressure of the lower nip roller pair 123, but as described hereinabove, by enabling active control of the contact pressure of the upper and lower nip roller pairs 121, 123', it is possible to control the contact pressure of the upper and lower nip roller pairs 121, 123' in a region with a small contact pressure within a wide range including zero. As has already been mentioned above, with the nip roller pairs 121, 123' according to the third embodiment, a stable pressurization state can be obtained in a region with a small contact pressure. Therefore, such an embodiment is advantageous with a configuration in which the contact pressure of these upper and lower nip roller pairs 121, 123' is actively controlled.

### (Fourth Embodiment)

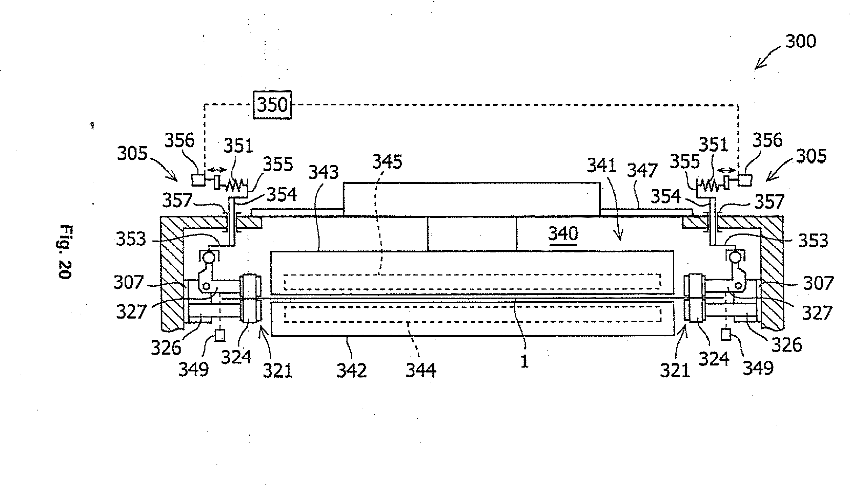

The first to third embodiments relate to the apparatus 100 for manufacturing a thin-film laminate in which films are formed, while conveying a strip-like flexible substrate transversely in a vertical posture. However, the position control device in accordance with the present invention can be also implemented in an apparatus 300 for manufacturing a thin-film laminate in which films are formed, while conveying a strip-like flexible substrate horizontally in a transverse posture, as in the fourth embodiment illustrated by FIG. 20.

Referring to FIG. 20, in the manufacturing apparatus 300 of the fourth embodiment of the present invention, a film forming unit 341 composed of electrodes 345 (targets) that nip the flexible substrate 1 and are disposed opposite each other above and below the flexible substrate and a ground electrode 344 is provided inside a chamber structure unit 340 (vacuum chamber) maintained under a predetermined degree of vacuum. Guide rolls (idle rolls), feed rolls, and tension rolls constituting conveying means are provided upstream and downstream of the film forming unit 341 in the conveying direction and the unwinding rolls and winding rolls for the flexible substrate 1 are provided upstream and downstream of the aforementioned rolls in the conveying direction. This configuration is similar to that of the above-described embodiments. The obvious difference is that the rotating shafts of all of the rolls are oriented horizontally.

The manufacturing apparatus 300 is provided with nip roller pairs 321, 321 that nip the side edge portions in the widthwise direction of the flexible substrate 1 and control mechanisms 305, 305 (contact pressure adjusting units) at both sides in the widthwise direction of the conveying path of the flexible substrate 1. The nip roller pairs 321, 321 are composed of pairs of nip rollers 324, 325 with rotating shafts inclined so that rotation directions thereof in a nipping portion face widthwise outward at slight bias angles (α, β) with respect to the conveying direction of the flexible substrate 1.

The fixed roller 324 is rotatably supported at the distal end of a fixed support member 326, and the movable roller 325 is rotatably supported at the distal end of a movable support member 327. The nip roller pairs 321 and the control mechanisms 305 thereof have configurations that are basically similar to those of the direct-type control mechanism 5" of the variation example (FIG. 9) of the first embodiment, except that the fixed rollers 324 (fixed support members 326) are disposed transverse so as to be on the lower side and the movable support members 327 are bent in the vicinity of the swinging shaft.

Springs 351, 351 that apply a contact pressure to the nip roller pairs 321, 321 are both provided outside the vacuum chamber (340), support points of the springs 351, 351 are displaced linearly by reciprocating drive of actuators 356, 356, the respective controlled biasing forces are transmitted to the movable support members 327, 327 located inside the vacuum chamber via a lever 355, a rotating shaft 354, and an operation arm 353 constituting a biasing force transmission mechanism, and contact pressures (nipping pressures) of the nip roller pairs 321, 321 are individually adjusted.

Since the flexible substrate 1 is conveyed in a state in which the widthwise side edges thereof are nipped by such nip roller pairs 321, 321, a stretching force acting widthwise outward is applied in response to the contact pressure (nipping pressure) of the nip roller pairs 321, 321 to both side edges of the flexible substrate 1 and the flexible substrate 1 is stretched widthwise. Sensors 349, 349 detecting the positions of side edges of the flexible substrate 1 are provided at both sides in the widthwise direction of the conveying path of the flexible substrate 1, and the actuators 356, 356 are individually reciprocatingly driven by the control unit 350 on the basis of the detection of the sensors 349, 349, whereby the contact pressure (nipping pressure) of the nip roller pairs 321, 321 is controlled and the widthwise position of the flexible substrate 1 is controlled in response thereto.

In the manufacturing apparatus 300, the ground electrode 344 is provided at the lower surface side of the flexible substrate 1, the effect produced by the own weight of the flexible substrate 1 is small and the same on the nip roller pairs 321, 321 on each side. Therefore, the initial displacement of springs 351, 351 on each side and the control amount of each actuator 356, 356 are set basically identically. The control of the contact pressure (nipping pressure) by the actuators 356, 356 is implemented individually and in coordination by the control unit 350 on the basis of detection of the sensors 349 in order to correct widthwise displacement and meandering of the flexible substrate 1, while stretching the flexible substrate 1 in the widthwise direction.

As clearly follows from FIG. 20, the nip roller pairs 321 and control mechanisms 305 thereof are similar to the direct-type control mechanism 5" (FIG. 9) according to the variation example of the first embodiment. Therefore, the control mechanism 105 (FIGS. 13 to 16) of the toggle spring type of the third embodiment, which is a development thereof, can be also used. Further, the above-described configuration can be also adapted to both the step film forming system and the continuous film forming system, in the same manner as in the above-described first to third embodiments.

Several embodiments of the present invention are described above, but the present invention is not limited to these embodiments and various changes and modifications thereof can be made on the basis of the technical concept of the present invention.

For example, in the above-described embodiments, the configurations are described in which coil springs are used as biasing members (springs 51, 51', 81, 81', 81", 82, 82', 82", 160, 260), but other types of springs such as spiral springs or torsion bars can be used. Further, in the first and second embodiments, the configurations are described in which compressive springs are used as biasing members, but the apparatus can be also configured by using tension springs.

In the above-described embodiments, the configurations are described in which upper nip roller pairs 21, 22... (121, 122...) and lower nip roller pairs 23... (123...) are provided between the adjacent units among a large number of film forming units 41 provided side by side along the conveying path of the flexible substrate 1 and the contact pressure of one upper nip roller pair 21 (121) that is an almost central pair can be controlled, but it is also possible to control the contact pressure of a plurality of upper nip roller pairs 21 (121). Further, when the length of the film forming unit 41 in the conveying direction is comparatively small, a nip roller pair can be disposed for each unit or for every two units, and when the number of film forming units 41 is small (for example, two units) and the conveying span is comparatively short, the substrate position control device can be also constituted by the controllable upper nip roller pair 21 (121) and a lower nip roller pair 23 (123) of a constant contact pressure that is disposed below the upper nip roller pair, or the substrate position control device can be constituted only by the controllable upper nip roller pair 21 (121). In the latter case, the position of the flexible substrate in the vertical width direction can be maintained by balancing the gravity force acting upon the flexible substrate 1 and the lifting force of the upper nip roller pair 21.

Further, in the above-described embodiments the case is described in which the present invention is implemented as an apparatus for manufacturing a thin-film laminate for a solar cell, but it goes without saying that the treatment apparatus for a flexible substrate in accordance with the present invention can be also applied to an apparatus for manufacturing a semiconductor film such as an organic EL as well as various treatment apparatuses in which position control or stretching of a flexible substrate are required in addition to film formation, such as apparatuses for coating, washing, drying, heat treating, and surface processing. Further, the present invention can be also implemented when a flexible substrate is conveyed in the transverse direction (including an oblique direction) in a vertical posture (or inclined posture), and when a flexible substrate is conveyed in the horizontal, vertical, or oblique direction in a transverse posture.

## Claims

1. A treatment apparatus for a flexible substrate, comprising:
conveying means for conveying a strip-like flexible substrate in a vertical posture thereof in a transverse direction;
a treatment unit for the flexible substrate disposed in a conveying path of the flexible substrate; and
a position control device that controls a widthwise position of the flexible substrate in the treatment unit, wherein
the position control device includes
a pair of upper nip rollers that nip an upper edge portion of the flexible substrate, rotating shafts of the pair of upper nip rollers being inclined so that a rotation direction in a nipping portion thereof faces obliquely upward at a slight bias angle with respect to a conveying direction of the flexible substrate,
an upper support mechanism including a movable support member and a fixed support member that support the pair of upper nip rollers so that the pair of upper nip rollers can be rotated and brought close to, or withdrawn from each other,
a biasing member that biases, via the movable support member, one of the pair of upper nip rollers in a direction of pressing against the other one of the pair of upper nip rollers, and
drive means for displacing the biasing member so as to adjust a nipping pressure of the pair of upper nip rollers.

2. A treatment apparatus for a flexible substrate, comprising:
conveying means for conveying a strip-like flexible substrate in a vertical posture thereof in a transverse direction;
a treatment unit for the flexible substrate disposed in a conveying path of the flexible substrate; and
a position control device that controls a widthwise position of the flexible substrate in the treatment unit, wherein
the position control device includes
a pair of upper nip rollers that nip an upper edge portion of the flexible substrate, rotating shafts of the pair of upper nip rollers being inclined so that a rotation direction in a nipping portion thereof faces obliquely upward at a slight bias angle with respect to a conveying direction of the flexible substrate,
an upper support mechanism including a movable support member and a fixed support member that support the pair of upper nip rollers so that the pair of upper nip rollers can be rotated and brought close to, or withdrawn from each other,
a biasing member that biases, via the movable support member, one of the pair of upper nip rollers in a direction of pressing against the other one of the pair of upper nip rollers,
a second biasing member that applies to the movable support member an adjusting force in a direction opposite to a biasing direction of the biasing member, and
drive means for displacing the second biasing member so as to adjust a nipping pressure of the pair of upper nip rollers.

3. The treatment apparatus for a flexible substrate according to claim 1, wherein
the treatment unit includes at least one film forming unit provided inside a vacuum chamber,
the pair of upper nip rollers, the upper support mechanism, and the biasing member are provided inside the vacuum chamber, and
the drive means includes an actuator provided outside the vacuum chamber and a drive transmission mechanism that transmits drive of the actuator via sealing means to the biasing member inside the vacuum chamber.

4. The treatment apparatus for a flexible substrate according to claim 1, wherein
the treatment unit includes at least one film forming unit provided inside a vacuum chamber,
the pair of upper nip rollers and the upper support mechanism are provided inside the vacuum chamber, and the biasing member is provided outside the vacuum chamber, and
the drive means includes an actuator provided outside the vacuum chamber and further includes a biasing force transmission mechanism that transmits a biasing force of the biasing member via sealing means to the movable support member inside the vacuum chamber.

5. The treatment apparatus for a flexible substrate according to claim 2, wherein
the treatment unit includes at least one film forming unit provided inside a vacuum chamber,
the pair of upper nip rollers, the upper support mechanism, and the biasing member are provided inside the vacuum chamber, and the second biasing member is provided outside the vacuum chamber, and
the drive means includes an actuator provided outside the vacuum chamber and further includes an adjusting force transmission mechanism that transmits an adjusting force of the second biasing member via sealing means to the movable support member inside the vacuum chamber.

6. The treatment apparatus for a flexible substrate according to claim 1 or 2, wherein
the position control device further includes
a pair of lower nip rollers that nip a lower edge portion of the flexible substrate, rotating shafts of the pair of lower nip rollers being inclined so that a rotation direction in a nipping portion thereof faces obliquely downward at a slight bias angle with respect to a conveying direction of the flexible substrate,
a lower support mechanism including a movable support member and a fixed support member that support the pair of lower nip rollers so that the pair of lower nip rollers can be rotated and brought close to, or withdrawn from each other, and
a lower biasing member that biases, via the movable support member, one of the pair of lower nip rollers in a direction of pressing against the other one of the pair of lower nip rollers.

7. A treatment apparatus for a flexible substrate, comprising:
conveying means for conveying a strip-like flexible substrate in a vertical posture thereof in a transverse direction;
a treatment unit for the flexible substrate disposed in a conveying path of the flexible substrate; and
a position control device that controls a widthwise position of the flexible substrate in the treatment unit, wherein
the position control device includes
a pair of upper nip rollers that nip an upper edge portion of the flexible substrate, rotating shafts of the pair of upper nip rollers being inclined so that a rotation direction in a nipping portion thereof faces obliquely upward at a slight bias angle with respect to a conveying direction of the flexible substrate,
a support mechanism including a movable support member and a fixed support member that support the pair of upper nip rollers so that the pair of upper nip rollers can be rotated and brought close to, or withdrawn from each other,
a spring that generates a biasing force that presses, via the movable support member, one of the pair of upper nip rollers against the other one of the pair of upper nip rollers,
a transmission mechanism that transmits the biasing force of the spring as a torque to the movable support member, and
drive means for angularly displacing a support point of the spring about a point of connection to the transmission mechanism so as to adjust a nipping pressure of the pair of upper nip rollers.

8. The treatment apparatus for a flexible substrate according to claim 7, wherein the drive means includes a drive member that angularly displaces the support point of the spring about an axis passing through the point of connection to the transmission mechanism and parallel to a rotating shaft of the transmission mechanism, while maintaining a constant elastic displacement of the spring.

9. The treatment apparatus for a flexible substrate according to claim 7 or 8, wherein
the angular displacement of the support point induced by the drive means is a toggle angular position and includes a toggle angular position such that the transmission mechanism can be held by the biasing force of the spring supported in the toggle angular position in two positions: a position in which the one of the pair of nip rollers is pressed against the other one of the pair of nip rollers; and a position in which the one of the pair of nip rollers is withdrawn from the other one of the pair of nip rollers.

10. The treatment apparatus for a flexible substrate, according to claim 7, wherein
the position control device further includes
a pair of lower nip rollers that nip a lower edge portion of the flexible substrate, rotating shafts of the pair of lower nip rollers being inclined so that a rotation direction in a nipping portion thereof faces obliquely downward at a slight bias angle with respect to a conveying direction of the flexible substrate,
a lower support mechanism including a movable support member and a fixed support member that support the pair of lower nip rollers so that the pair of lower nip rollers can be rotated and brought close to, or withdrawn from each other, and
a lower spring that generates a biasing force that presses, via the movable support member, one of the pair of lower nip rollers against the other one of the pair of lower nip rollers.

11. The treatment apparatus for a flexible substrate, according to claim 1, 2, or 7, further comprising detection means for detecting a position of the flexible substrate in a vertical width direction, wherein
the position control device further includes a control unit for controlling the drive means on a basis of a detection value of the detection means.

12. A treatment apparatus for a flexible substrate, comprising:
conveying means for conveying a strip-like flexible substrate;
a treatment unit for the flexible substrate disposed in a conveying path of the flexible substrate; and
a position control device that controls a widthwise position of the flexible substrate in the treatment unit, wherein
the position control device includes
pairs of nip rollers that nip side edge portions of the flexible substrate, rotating shafts of the pairs of nip rollers being inclined so that rotation directions in nipping portions thereof face widthwise edges at a slight bias angle with respect to a conveying direction of the flexible substrate,
support mechanisms on each side including movable support members and fixed support members that support the pairs of nip rollers so that the pairs of nip rollers can be rotated and brought close to, or withdrawn from each other in each pair,
biasing members on each side that bias, via the movable support members, one of the nip rollers in each pair in a direction of pressing against the other one of the nip rollers, and
drive means for displacing at least one of the biasing members so as to adjust a nipping pressure of at least one of the pairs of nip rollers.

13. A treatment apparatus for a flexible substrate, comprising:
conveying means for conveying a strip-like flexible substrate;
a treatment unit for the flexible substrate disposed in a conveying path of the flexible substrate; and
a position control device that controls a widthwise position of the flexible substrate in the treatment unit, wherein
the position control device includes
pairs of nip rollers that nip side edge portions of the flexible substrate, rotating shafts of the pairs of nip rollers being inclined so that rotation directions in nipping portions thereof face widthwise edges at a slight bias angle with respect to a conveying direction of the flexible substrate,
support mechanisms on each side including movable support members and fixed support members that support the pairs of nip rollers so that the pairs of nip rollers can be rotated and brought close to, or withdrawn from each other in each pair,
biasing members on each side that bias, via the movable support members, one of the nip rollers in each pair in a direction of pressing against the other one of the nip rollers,
second biasing members on each side that apply to the movable support members an adjusting force in a direction opposite to a biasing direction of the biasing members, and
drive means for displacing at least one of the second biasing members so as to adjust a nipping pressure of at least one of the pairs of nip rollers.

14. A treatment apparatus for a flexible substrate, comprising:
conveying means for conveying a strip-like flexible substrate;
a treatment unit for the flexible substrate disposed in a conveying path of the flexible substrate; and
a position control device that controls a widthwise position of the flexible substrate in the treatment unit, wherein
the position control device includes
pairs of nip rollers that nip side edge portions of the flexible substrate, rotating shafts of the pairs of nip rollers being inclined so that rotation directions in nipping portions thereof face widthwise edges at a slight bias angle with respect to a conveying direction of the flexible substrate,
support mechanisms on each side including movable support members and fixed support members that support the pairs of nip rollers so that the pairs of nip rollers can be rotated and brought close to, or withdrawn from each other in each pair,
springs on each side that generate biasing forces that press, via the movable support members, one of the nip rollers in each pair against the other one of the nip rollers,
transmission mechanisms on each side that transmit the biasing forces of the springs as respective torques to the movable support members, and
drive means for angularly displacing a support point of at least one of the springs about a point of connection to the transmission mechanism so as to adjust a nipping pressure of at least one of the pairs of nip rollers.

## Amended claims

### Amended claims under Art. 19.1 PCT

**1.** (Amended) An apparatus for manufacturing a thin-film laminate by laminating a plurality of thin films on a surface of a strip-like flexible substrate, the apparatus comprising:
conveying means for conveying the flexible substrate in a vertical posture thereof in a transverse direction;
a film forming section disposed in a conveying path of the flexible substrate; and
a position control device that controls a widthwise position of the flexible substrate in the film forming section, wherein
the position control device includes
a pair of upper nip rollers that nip an upper edge portion of the flexible substrate, rotating shafts of the upper nip rollers being inclined so that a rotation direction in a nipping portion thereof faces obliquely upward at a slight bias angle with respect to a conveying direction of the flexible substrate,
an upper support mechanism including a movable support member and a fixed support member that support the pair of upper nip rollers so that the pair of upper nip rollers can be rotated and brought close to, or withdrawn from each other,
a biasing member that biases, via the movable support member, one of the pair of upper nip rollers in a direction of pressing against the other one of the pair of upper nip rollers, and
drive means for displacing the biasing member so as to adjust a nipping pressure of the pair of upper nip rollers.

**2.** (Amended) An apparatus for manufacturing a thin-film laminate by laminating a plurality of thin films on a surface of a strip-like flexible substrate, the apparatus comprising:
conveying means for conveying the flexible substrate in a vertical posture thereof in a transverse direction;
a film forming section disposed in a conveying path of the flexible substrate; and
a position control device that controls a widthwise position of the flexible substrate in the film forming section, wherein
the position control device includes
a pair of upper nip rollers that nip an upper edge portion of the flexible substrate, rotating shafts of the pair of upper nip rollers being inclined so that a rotation direction in a nipping portion thereof faces obliquely upward at a slight bias angle with respect to a conveying direction of the flexible substrate,
an upper support mechanism including a movable support member and a fixed support member that support the pair of upper nip rollers so that the pair of upper nip rollers can be rotated and brought close to, or withdrawn from each other,
a biasing member that biases, via the movable support member, one of the pair of upper nip rollers in the direction of pressing against the other one of the pair of upper nip rollers,
a second biasing member that applies to the movable support member an adjusting force in a direction opposite to a biasing direction of the biasing member, and
drive means for displacing the second biasing member so as to adjust a nipping pressure of the pair of upper nip rollers.

**3.** (Amended) The apparatus for manufacturing a thin-film laminate according to claim 1, wherein
the film forming section includes at least one film forming unit provided inside a vacuum chamber,
the pair of upper nip rollers, the upper support mechanism, and the biasing member are provided inside the vacuum chamber, and
the drive means includes an actuator provided outside the vacuum chamber and a drive transmission mechanism that transmits drive of the actuator via sealing means to the biasing member inside the vacuum chamber.

**4.** (Amended) The apparatus for manufacturing a thin-film laminate according to claim 1, wherein
the film forming section includes at least one film forming unit provided inside a vacuum chamber,
the pair of upper nip rollers and the upper support mechanism are provided inside the vacuum chamber, and the biasing member is provided outside the vacuum chamber, and
the drive means includes an actuator provided outside the vacuum chamber and further includes a biasing force transmission mechanism that transmits a biasing force of the biasing member via sealing means to the movable support member inside the vacuum chamber.

**5.** (Amended)
The apparatus for manufacturing a thin-film laminate according to claim 2, wherein
the film forming section includes at least one film forming unit provided inside a vacuum chamber,
the pair of upper nip rollers, the upper support mechanism, and the biasing member are provided inside the vacuum chamber, and the second biasing member is provided outside the vacuum chamber, and
the drive means includes an actuator provided outside the vacuum chamber and further includes an adjusting force transmission mechanism that transmits an adjusting force of the second biasing member via sealing means to the movable support member inside the vacuum chamber.

**6.** (Amended)
The apparatus for manufacturing a thin-film laminate according to claim 1 or 2, wherein
the position control device further includes
a pair of lower nip rollers that nip a lower edge portion of the flexible substrate, rotating shafts of the pair of lower nip rollers being inclined so that a rotation direction in a nipping portion thereof faces obliquely downward at a slight bias angle with respect to a conveying direction of the flexible substrate,
a lower support mechanism including a movable support member and a fixed support member that support the pair of lower nip rollers so that the pair of lower nip rollers can be rotated and brought close to, or withdrawn from each other, and
a lower biasing member that biases, via the movable support member, one of the pair of lower nip rollers in a direction of pressing against the other one of the pair of lower nip rollers.

**7.** A treatment apparatus for a flexible substrate, comprising:
conveying means for conveying a strip-like flexible substrate in a vertical posture thereof in a transverse direction;
a treatment unit for the flexible substrate disposed in a conveying path of the flexible substrate; and
a position control device that controls a widthwise position of the flexible substrate in the treatment unit, wherein
the position control device includes
a pair of upper nip rollers that nip an upper edge portion of the flexible substrate, rotating shafts of the pair of upper nip rollers being inclined so that a rotation direction in a nipping portion thereof faces obliquely upward at a slight bias angle with respect to a conveying direction of the flexible substrate,
a support mechanism including a movable support member and a fixed support member that support the pair of upper nip rollers so that the pair of upper nip rollers can be rotated and brought close to, or withdrawn from each other,
a spring that generates a biasing force that presses, via the movable support member, one of the pair of upper nip rollers against the other one of the pair of upper nip rollers,
a transmission mechanism that transmits the biasing force of the spring as a torque to the movable support member, and
drive means for angularly displacing a support point of the spring about a point of connection to the transmission mechanism so as to adjust a nipping pressure of the pair of upper nip rollers.

**8.** The treatment apparatus for a flexible substrate according to claim 7, wherein the drive means includes a drive member that angularly displaces the support point of the spring about an axis passing through the point of connection to the transmission mechanism and parallel to a rotating shaft of the transmission mechanism, while maintaining a constant elastic displacement of the spring.

**9.** The treatment apparatus for a flexible substrate according to claim 7 or 8, wherein
the angular displacement of the support point induced by the drive means is a toggle angular position and includes a toggle angular position such that the transmission mechanism can be held by the biasing force of the spring supported in the toggle angular position in two positions: a position in which the one of the pair of nip rollers is pressed against the other one of the pair of nip rollers; and a position in which the one of the pair of nip rollers is withdrawn from the other one of the pair of nip rollers.

**10.** The treatment apparatus for a flexible substrate, according to claim 7, wherein
the position control device further includes
a pair of lower nip rollers that nip a lower edge portion of the flexible substrate, rotating shafts of the pair of lower nip rollers being inclined so that a rotation direction in a nipping portion thereof faces obliquely downward at a slight bias angle with respect to a conveying direction of the flexible substrate,
a lower support mechanism including a movable support member and a fixed support member that support the pair of lower nip rollers so that the pair of lower nip rollers can be rotated and brought close to, or withdrawn from each other, and
a lower spring that generates a biasing force that presses, via the movable support member, one of the pair of lower nip rollers against the other one of the pair of lower nip rollers.

**11.** The treatment apparatus for a flexible substrate, according to claim 1, 2, or 7, further comprising detection means for detecting a position of the flexible substrate in a vertical width direction, wherein
the position control device further includes a control unit for controlling the drive means on a basis of a detection value of the detection means.

**12.** A treatment apparatus for a flexible substrate, comprising:
conveying means for conveying a strip-like flexible substrate;
a treatment unit for the flexible substrate disposed in a conveying path of the flexible substrate; and
a position control device that controls a widthwise position of the flexible substrate in the treatment unit, wherein
the position control device includes
pairs of nip rollers that nip side edge portions of the flexible substrate, rotating shafts of the pairs of nip rollers being inclined so that rotation directions in nipping portions thereof face widthwise edges at a slight bias angle with respect to a conveying direction of the flexible substrate,
support mechanisms on each side including movable support members and fixed support members that support the pairs of nip rollers so that the pairs of nip rollers can be rotated and brought close to, or withdrawn from each other in each pair,
biasing members on each side that bias, via the movable support members, one of the nip rollers in each pair in a direction of pressing against the other one of the nip rollers, and
drive means for displacing at least one of the biasing members so as to adjust a nipping pressure of at least one of the pairs of nip rollers.

**13.** A treatment apparatus for a flexible substrate, comprising:
conveying means for conveying a strip-like flexible substrate;
a treatment unit for the flexible substrate disposed in a conveying path of the flexible substrate; and
a position control device that controls a widthwise position of the flexible substrate in the treatment unit, wherein
the position control device includes
pairs of nip rollers that nip side edge portions of the flexible substrate, rotating shafts of the pairs of nip rollers being inclined so that rotation directions in nipping portions thereof face widthwise edges at a slight bias angle with respect to a conveying direction of the flexible substrate,
support mechanisms on each side including movable support members and fixed support members that support the pairs of nip rollers so that the pairs of nip rollers can be rotated and brought close to, or withdrawn from each other in each pair,
biasing members on each side that bias, via the movable support members, one of the nip rollers in each pair in a direction of pressing against the other one of the nip rollers,
second biasing members on each side that apply to the movable support members an adjusting force in a direction opposite to a biasing direction of the biasing members, and
drive means for displacing at least one of the second biasing members so as to adjust a nipping pressure of at least one of the pairs of nip rollers.

**14.** A treatment apparatus for a flexible substrate, comprising:
conveying means for conveying a strip-like flexible substrate in a vertical posture thereof in a transverse direction;
a treatment unit for the flexible substrate disposed in a conveying path of the flexible substrate; and
a position control device that controls a widthwise position of the flexible substrate in the treatment unit, wherein
the position control device includes
pairs of nip rollers that nip side edge portions of the flexible substrate, rotating shafts of the pairs of nip rollers being inclined so that rotation directions in nipping portions thereof face widthwise edges at a slight bias angle with respect to a conveying direction of the flexible substrate,
support mechanisms on each side including movable support members and fixed support members that support the pairs of nip rollers so that the pairs of nip rollers can be rotated and brought close to, or withdrawn from each other in each pair,
springs on each side that generate biasing forces that press, via the movable support members, one of the nip rollers in each pair against the other one of the nip rollers,
transmission mechanisms on each side that transmit the biasing forces of the springs as respective torques to the movable support members, and
drive means for angularly displacing a support point of at least one of the springs about a point of connection to the transmission mechanism so as to adjust a nipping pressure of at least one of the pairs of nip rollers.

**15.** (Added)
The apparatus for manufacturing a thin-film laminate according to any one of claims 3 to 5, wherein the sealing means is a seal bearing, the drive transmission mechanism, the biasing force transmission mechanism, or the adjusting force transmission mechanism includes a shaft that is air-tightly and rotatably supported by the seal bearing, and a rotational force is transmitted from outside to inside of the vacuum chamber via the shaft.

In claims 1 to 6, the object is restricted to "an apparatus for manufacturing a thin-film laminate", so that the scope thereof be included in the range disclosed in the priority document (Japanese Patent Application No. 2009-327299) of the present application, with consideration for the Written Opinion of the International Searching Authority.

As a result, the claim for priority relating to claims 1 to 6 becomes effective and a reference date for determining the novelty and inventive step of the invention as in claims 1 to 6 can be considered to be a priority date of December 24, 2009.

According to the description of paragraph [0020] of the Detailed Description of the Invention of the present application, claim 15 depends on claims 3 to 5.
